# EUROPÄISCHE PATENTSCHRIFT

(11) **EP 3 152 785 B1**
(45) Veröffentlichungstag und Bekanntmachung des Hinweises auf die Patenterteilung: **29.11.2017**
(21) Anmeldenummer: 16753340.5
(22) Anmeldetag: 12.08.2016
(51) Int. Cl.: H01L 27/30, H01L 51/44

(54) **VERFAHREN ZUR DETEKTION UND UMWANDLUNG VON INFRAROTER ELEKTROMAGNETISCHER STRAHLUNG**
METHOD FOR DETECTING AND CONVERTING INFRARED ELECTROMAGNETIC RADIATION
PROCÉDÉ DE DÉTECTION ET DE CONVERSION DE RAYONNEMENT ÉLECTROMAGNÉTIQUE INFRAROUGE

(30) Priorität: 14.08.2015 DE 102015215581
(43) Veröffentlichungstag der Anmeldung: 12.04.2017
(73) Patentinhaber: Technische Universität Dresden, 01069 Dresden (DE)
(72) Erfinder: SIEGMUND, Bernhard, 01067 Dresden (DE); VANDEWAL, Koen, 01069 Dresden (DE); MISCHOK, Andreas, 01159 Dresden (DE); BENDUHN, Johannes, 01307 Dresden (DE); SPOLTORE, Donato, 01069 Dresden (DE); KÖRNER, Christian, 01237 Dresden (DE); LEO, Karl, 01219 Dresden (DE)
(74) Vertreter: Kailuweit & Uhlemann Patentanwälte Partnerschaft mbB
(86) Internationale Anmeldenummer: PCT/EP2016/069256
(87) Internationale Veröffentlichungsnummer: WO 2017/029223

(56) Entgegenhaltungen:
- US-A1- 2004 016 923
- BEDNORZ MATEUSZ ET AL: "Silicon/organic hybrid heterojunction infrared photodetector operating in the telecom regime", ORGANIC ELECTRONICS, ELSEVIER, AMSTERDAM, NL, Bd. 14, Nr. 5, 14. März 2013 (2013-03-14), Seiten 1344-1350, XP028579696, ISSN: 1566-1199, DOI: 10.1016/J.ORGEL.2013.02.009

## Beschreibung

Die vorliegende Erfindung betrifft ein Verfahren zur Detektion von infraroter elektromagnetischer Strahlung bzw. deren Umwandlung in ein elektrisches Signal, ein optoelektronisches Bauelement, insbesondere einen organischen Infrarotdetektor für (Nah-)Infrarot-Detektion, und dessen Verwendung für die Detektion eines elektromagnetischen Signals im Wellenlängenbereich von 780 nm bis 10 µm.

Photosensitive, optoelektronische Bauelemente wandeln elektromagnetische Umgebungsstrahlung in Elektrizität um. Die Bauelementklasse umfasst Solarzellen und Detektoren. Solarzellen sind optimiert, um einen größtmöglichen Anteil des Sonnenlichtes in elektrische Leistung umzuwandeln. Detektoren hingegen werden häufig mit einer extern angelegten Spannung betrieben (und sind dementsprechend nicht energieautark), um höhere externe Quanteneffizienzen im Detektionsbereich und schnellere Reaktionszeiten zu erzielen. Weiterhin kann ihr Detektionsbereich außerhalb des sichtbaren Lichtes liegen. Häufig ist ihnen eine Einrichtung zum Auslesen und Weiterverarbeiten der vom optoelektronischen Bauelement generierten Stromstärke angeschlossen.

Aus dem Stand der Technik sind vielfältige Lösungsansätze für Infrarot-Detektoren (IR-Detektoren) bekannt, die entsprechend ihrer Funktionsweise in fünf Kategorien eingeteilt werden. Dabei unterscheidet der Fachmann:
1. Es sind Detektoren bekannt, die auf der Singulett-Absorption eines Halbleiters beruhen, bei der Elektronen aus einem voll besetzten Zustand (Valenzband-Energie bzw. HOMO-Energie oder energetisch tiefer) in ein unbesetztes Niveau (Leitungsband-Energie bzw. LUMO-Energie oder energetisch höher) angehoben werden. Anhand des eingesetzten aktiven Mediums lässt sich weiterhin in folgende vier Gruppen untergliedern:
   a) Die Anorganik-basierten IR-Detektoren beruhen zumeist auf dem Einsatz seltener Erden, wie bspw. Indium oder Gallium, wobei deren Herstellung technologisch anspruchsvoll und daher nachteilig energieintensiv und insbesondere kostenintensiv ist. Gleichwohl sind Anorganik-basierte IR-Detektoren mechanisch unflexibel und führen zu voluminöseren bzw. schwereren Bauteilen im Vergleich zu auf Organik beruhenden Lösungsansätzen (Downs und Vandervelde, Sensors 2013, 13, doi:10.3390/s130405054).
   b) In einer weiteren Anorganik-basierten Ausführung werden bleihaltige Salze wie Blei(11)sulfid verwendet, die jedoch wesentlich langsamere Reaktionszeiten als in 1a) aufweisen und aufgrund von Blei als besonders toxisch einzustufen sind (Humphrey, Appl. Opt. 1965 4, 665-675).
   c) Bei Organik-basierten IR-Detektoren, die durch die Vakuumprozessierung organischer Verbindungen hergestellt werden, ist insbesondere nachteilig, dass nur wenige dieser IR-Detektoren eine Absorption bei Wellenlängen höher als 1000 nm aufweisen (Baeg et al., Advanced Materials 2013, 25(31), 4267-4295). Dies beruht auf den hohen thermostabilen Anforderungen zur Sublimation, die im Widerspruch zu organischen Halbleitern mit niederenergetischer Bandlücke (d.h. Absorption im nahinfraroten Wellenlängenbereich) steht.
   d) Organik-basierte IR-Detektoren können alternativ auch mittels Lösungsmittel-Prozessierung hergestellt werden, wobei nur wenige Zusammensetzungen für photoaktive Schichten mit Singulett-Absorption oberhalb von 1000nm, wie bspw. die Kombination aus Zink-porphyrin-dimer mit Phenyl-C61-Buttersäuremethylester (kurz PCBM)und 4,4'-Bipyridil (kurz Bipy)-Addititv, in der Literatur beschrieben sind. Gleichwohl nachteilig ist, dass die maximale externe Quanteneffizienz dieser IR-Detektoren unter Kurzschluss-Bedingungen auf 13.5% (bei 1400nm) begrenzt ist.
   e) Kohlenstoff-basierte IR-Detektoren, in denen insbesondere Kohlenstoff-Nanoröhren oder Graphen-Monolagen zum Einsatz kommen, weisen unter Kurzschluss-Bedingungen deutlich geringere maximale externe Quanteneffizienzen von 2,3% bzw. 2% auf und erlauben zugleich lediglich eine breitbandige Absorption von 400 nm bis 1600 nm, so dass das optoelektronische Bauelement nicht selektiv sensitiv für IR-Strahlung ist (Gong et al., ACS Applied Materials & Interfaces 2015, 150330161533004. doi:10.1021/acsami.5b01536 bzw. Furchi et al., Nano Letters 2012, 12(6), 2773-2777).
2. Es sind auch IR-Detektoren bekannt, die auf der Absorption des direkten interchromophoren Ladungstransferzustands basieren, die entsprechend des eingesetzten aktiven Mediums untergliedert werden:
   a) Bednorz et al. (Organic Electronics: Physics, Materials, Applications 2013, 14(5), 1344-1350) offenbaren, dass bei hybriden IR-Detektoren, die sich die Absorption des direkten interchromophoren Ladungstransferzustands am Übergang einer organischen Schicht (bspw. Perylene-Derivate) zu einer anorganischen (bspw. Silizium) zu Nutze machen. Die Autoren berichten bei einer Wellenlänge von 1550 nm von einer geringen externen Quanteneffizienz (EQE) von deutlich weniger als 1%. Weiterhin nachteilig sind derartige IR-Detektoren mechanisch unflexibel und deren Herstellung erfordert seltene Erden, wie bspw. Indium oder Gallium, was die Herstellungskosten stark erhöht.
   b) Aus der Veröffentlichung Wu et al. (Energy & Environmental Science 2011, 4(9), 3374. doi:10.1039/c1ee01723c) ist die Absorption des direkten interchromophoren Ladungstransferzustands zwischen einem organischen Halbleiter und Fullerenen bekannt, im Speziellen aus der Mischschicht Poly(3-hexylthiophen) (kurz P3HT) mit Phenyl-C61-Buttersäuremethylester (kurz PCBM). Aufgrund des sehr schwachen Absorptionskoeffizienten führt deren photoaktive Schicht von 125 nm lediglich zu einer EQE von 0.05% bei elektromagnetischer Bestrahlung mit einer Wellenlänge von 980 nm. Auch Beenken et al. (Phys. Chem. Chem. Phys. 2013, 15, 16494. doi: 10.1039/c3cp42236d) leiten aus der Betrachtung von Absorptionsspektren der gleichen Mischschicht (P3HT:PCBM) eine geringe Oszillatorstärke des direkten interchromophoren Ladungstransfers (intermolecular charge-transfer transition) ab. Die entstehenden Ladungstransfer-Exzitonen werden als thermisch stabil angenommen, was keine oder nur eine höchst geringe Photostrom-Erzeugung mittels des betrachteten Ladungstransferzustands impliziert.
      Aus US 2009/0289247 A1 sind effizientere IR-Detektoren bekannt, die photoaktive Schichten dicker als 10 µm vorschlagen, um die Absorption des direkten interchromophoren Ladungstransferzustandes zu steigern. Zum effektiven Betreiben derartiger IR-Detektoren sind allerdings hohe Betriebsspannungen von 100 V oder mehr erforderlich, um den hohen elektrischen Widerstand der photoaktiven Schicht zu überwinden, deren Schichtdicke hier zwei oder drei Größenordnungen über den in Solarzellen üblichen Dicken liegt. Damit gehen nachteilig größere Dunkelströme einher und ein sehr geringes An-Aus-Verhältnis des Photostroms gegenüber des Dunkelstromes kleiner fünf. Mit dem ineffektiven Ladungsträgertransport einher gehen auch langsame Reaktionszeiten des Photostroms auf zeitliche Änderungen der zu detektierenden Strahlung.
      In der Fachliteratur, z. B. von Jailaubekov et al. (Nature Materials 2013, 12, 66), wird bisher die Auffassung vertreten, dass der Ladungstransferzustand als Falle für photoinduzierte Ladungsträger fungiert und daher nicht zum Photostrom beiträgt.
3. Liu et al. (Nano Letters 2014, 14(7), 3702-3708) beschreiben als weitere Möglichkeit zur Detektion von IR-Strahlung die Modulation der Leitfähigkeit durch Lichtabsorption. Besonders nachteilig ist hierbei das geringe An-Aus-Verhältnis der elektrischen Leitfähigkeit von lediglich 5%.
4. Ferner sind dem Fachmann IR-Detektoren bekannt, die auf der Absorption durch Oberflächen-Plasmonen basieren. Da diese Detektoren auf Anorganik-basierten Absorbermaterialien beruhen, weisen derartige IR-Detektoren die oben genannten Nachteile auf, die mit der Verwendung von anorganischen Materialien einhergehen. Zudem ist die maximal detektierbare Wellenlänge durch die Höhe der Schottky-Barriere begrenzt.
5. Schließlich sind auch quantisierte Übergänge, wie bspw. die Intersubband-Absorption in Quantentopfstrukturen oder Übergänge in Quantenpunkten bekannt, die nachteilig ebenfalls auf Anorganik-basierten Absorbermaterialien basieren. Auch diese Detektoren beruhen zumeist auf dem Einsatz seltener Erden, wie bspw. Indium oder Gallium, wobei deren Herstellung technologisch anspruchsvoll, daher nachteilig energieintensiv und insbesondere kostenintensiv ist. Außerdem sind Anorganik-basierte IR-Detektoren mechanisch unflexibel und führen zu voluminöseren bzw. schwereren Bauteilen im Vergleich zu auf Organik beruhenden Lösungsansätzen.

Eine Vorrichtung, die auch als IR-Sensor genutzt werden kann, ist aus der US 2004/0016923 A1 bekannt. Die offenbarten Matrixanordnungen können eine organische Multischicht-Struktur aufweisen, die sich innerhalb einer Mikrokavität, bestehend aus zwei Elektroden, befindet. Als Mechanismus zur Generierung eines Photostroms wird der photoinduzierte Ladungstransfer genannt. Der Definition des IUPAC Gold Books (doi: 10.1351/goldbook) gemäß handelt es sich beim photoinduzierten Elektronenübergang um einen Elektronenübergang als Ergebnis eines elektronischen Zustands, der aufgrund resonanter Wechselwirkung elektromagnetischer Strahlung mit Materie entsteht. Es handelt sich dabei um einen mehrteiligen Prozess, der vor dem eigentlichen Ladungstransfer zunächst die Bildung eines angeregten Zustands, etwa eines Donor-Exzitons, voraussetzt. Für die einzelnen Dünnschichten sind Materialien mit hoher Extinktion (z. B. MEH-PPV oder Sexithiophen) aufgeführt, die sich für sensitive Spektroskopie in einem ausreichend breiten Wellenlängenbereich nicht eignen.

Der Einsatz von Transportschichten in photosensitiven organischen Bauelementen zur effektiven Entnahme getrennter Ladungsträger als Photostrom aus dem Bauelement ist beispielsweise aus Zhou et al. (Polymer 2013, 54, 6501) bekannt. Bei den hier offenbarten Bauelementen erfolgt keine Optimierung der Schichtdicke hinsichtlich einer Resonanzwellenlänge im Absorptionsbereich des Ladungstransferzustandes.

Es ist daher Aufgabe der vorliegenden Erfindung, ein Verfahren für die Detektion elektromagnetischer Strahlung anzugeben, welches die vorbenannten Nachteile aus dem Stand der Technik überwindet und folglich kostengünstige, leichte, mechanisch flexible Infrarotdetektoren mit hoher externer Quanteneffizienz darstellen, die sich durch einen hohen Freiheitsgrad der Wahl der Detektionswellenlänge, insbesondere zur Verwendung im spektralen Wellenlängenbereich 780 nm bis 10 µm auszeichnen.

Die Aufgabe wird durch ein Verfahren nach Anspruch 1 sowie eine Vorrichtung zur Detektion eines elektromagnetischen Signals gemäß nachfolgender Ansprüche gelöst. Vorteilhafte Ausgestaltungen sind in den abhängigen Ansprüchen angegeben.

Das erfindungsgemäße Verfahren zur Detektion eines elektromagnetischen Signals im Wellenlängenbereich von 780 nm bis 10 µm weist die folgenden Schritte auf:
a) Bereitstellung eines optoelektronischen Bauelements, das auf einem Substrat angeordnet ist und
   **i**. zwei voneinander beabstandete und sich gegenüberliegende Spiegelflächen aufweist, die eine optische Mikrokavität ausbilden,
   **ii.** eine zwischen den Spiegelflächen angeordnete photoaktive Schicht aufweist, enthaltend mindestens eine Verbindung 1 und eine Verbindung 2,
   wobei die Energiedifferenz zwischen der HOMO-Energie der Verbindung 1 und der LUMO-Energie der Verbindung 2 unterhalb 1,6 eV liegt,
   wobei die optische Weglänge zwischen den Spiegelflächen im Bereich von 25% bis 75% der Wellenlänge des zu detektierenden elektromagnetischen Signals entspricht und
   wobei das Energieäquivalent des Wellenlängenbereichs des zu detektierenden elektromagnetischen Signals im Bereich von
   - der Energiedifferenz definiert durch die HOMO-Energie der Verbindung 1 und die LUMO-Energie der Verbindung 2 und
   - der Energiedifferenz definiert durch die HOMO-Energie und die LUMO-Energie der Verbindung 1 liegt,
   wobei die photoaktive Schicht innerhalb der optischen Mikrokavität im räumlichen Intensitätsmaximum der Wellenlänge des zu detektierenden elektromagnetischen Signals zwischen den Spiegelflächen ausgerichtet ist,
b) Bestrahlen des optoelektronischen Bauelements mit einem elektromagnetischen Signal im Wellenlängenbereich von 780 nm bis 10 µm,
c) Verstärkung des zu detektierenden elektromagnetischen Signals innerhalb der optischen Mikrokavität, wobei durch die Wellenlänge des zu detektierenden Signals induziert ein direkter interchromophorer Ladungstransfer von der Verbindung 1 auf die Verbindung 2 erfolgt,
d) Umwandlung des elektromagnetischen Signals in ein elektrisches Signal.

Das globale Maximum der externen Quanteneffizienz (kurz EQE) des erfindungsgemäßen optoelektronischen Bauelements liegt im Bereich der Absorption des direkten interchromophoren Ladungstransferzustandes und ist im Vergleich zur höchsten EQE aus dem Wellenbereich der Singulett-Absorption mindestens gleich groß, insbesondere mindestens um den Faktor zwei höher, ganz insbesondere um den Faktor fünf höher.

Der vorliegenden Erfindung liegt die überraschende Erkenntnis zugrunde, dass die schwache Absorption des Zustandes an der Grenzfläche der Verbindung 1 und der Verbindung 2, der sogenannte direkte interchromophore Ladungstransfer, mittels der erfindungsgemäß gewählten Anordnung der Spiegelflächen effizient verstärkt werden kann.

Im Gegensatz zu herkömmlichen organischen Solarzellen wird im Sinne der Erfindung auf die Diffusion von durch Singulett-Absorption erzeugten Exzitonen zur Donor-Akzeptor-Grenzfläche verzichtet und stattdessen direkt der Übergang an der Grenzfläche zwischen Donor und Akzeptor durch Absorption angeregt. Somit wird erfindungsgemäß ein optoelektronisches Bauelement zur Detektion von elektromagnetischer Strahlung, insbesondere im nahen und mittleren Infrarotbereich, bereitgestellt, welches selektiv ein elektromagnetisches Signal aus der Gesamtheit einfallender elektromagnetischer Strahlung in ein elektrisches Signal umwandelt. Das auf dem direkten interchromophoren Ladungstransfer basierende erfindungsgemäße Verfahren ist insbesondere unerwartet für den Fachmann, da in der wissenschaftlichen Fachliteratur bisher die Auffassung vertreten wird, dass der Ladungstransferzustand als Falle für photoinduzierte Ladungsträger fungiert und daher nicht zum Photostrom beiträgt.

Die Singulett-Absorption beschreibt den einzigen Absorptionsmechanismus in einer reinen, d.h. nur aus einer organischen Verbindung aufgebauten, organischen Halbleiterschicht. Die Singulett-Absorption ist die Absorption eines Photons, die zur Anhebung eines Elektrons aus dem HOMO-Energieniveau (oder niedriger) in das LUMO-Energieniveau (oder höher) führt. Dabei hinterlässt das Elektron im HOMO eine Fehlstelle (sogenanntes Loch), welches elektrostatisch durch Coulomb-Wechselwirkung mit dem angeregten Elektron gebunden ist. Der gebundene Zweiteilchenzustand wird als Exziton zusammengefasst. Aufgrund der Exzitonenbindungsenergie können auch Anregungsenergien 100 meV geringer als der energetische Abstand zwischen LUMO- und HOMO-Energie zur Singulett-Absorption führen.

Des Weiteren unterscheidet der Fachmann grundsätzlich zwischen intermolekularen und intramolekularen Ladungstransfer-Übergängen, bzw. den daraus resultierenden angeregten Ladungstransferzuständen (englisch charge transfer state oder kurz CT-state).

Bei einem Ladungstransfer-Übergang handelt es sich um eine vollständige oder nahezu vollständige Ladungsübertragung von einer Donorverbindung auf eine Akzeptorverbindung. Sind beide Verbindungen im gleichen Molekül verankert, so liegt ein intramolekularer Ladungstransfer-Übergang vor. Wirken verschiedene (diskrete) Moleküle oder Ionen, die auch lose durch koordinative Wechselwirkung gekoppelt sein können, als Donorverbindung und Akzeptorverbindung, so spricht man von einem intermolekularen Ladungstransfer. Gemäß der Definition des IUPAC Gold Books (doi:10.1351/goldbook) ist ein Ladungstransfer-Übergang ein elektronischer Übergang, bei welchem ein großer Teil einer elektrischen Ladung von einem Bereich einer molekularen Einheit, genannt Elektronen-Donor, auf einen anderen, genannt Elektronenakzeptor (intramolekularer Ladungstransfer), oder von einer molekularen Einheit auf eine andere (intermolekularer Ladungstransfer) übertragen wird. Der Ladungstransfer-Übergang ist typisch für Donor-Akzeptor-Komplexe oder multichromophore molekulare Einheiten.

Ein intermolekularer Ladungstransferzustand ist ein schwach gebundener Zustand zwischen einem angeregtem Elektron im LUMO (oder einem energetisch höher liegendem Zustand) sowie einem Loch im HOMO (oder energetisch niedriger), wobei das genannte Loch und Elektron sich auf räumlich getrennten Molekülen befinden. Vorzugsweise bildet sich der Ladungstransferzustand an der Grenzfläche zwischen Verbindung 1 und Verbindung 2 aus.

Der intramolekulare Ladungstransferzustand basiert auf einer Elektronen-Donor- und einer Elektronen-Akzeptor-Struktur-Einheit innerhalb eines einzelnen Moleküls.

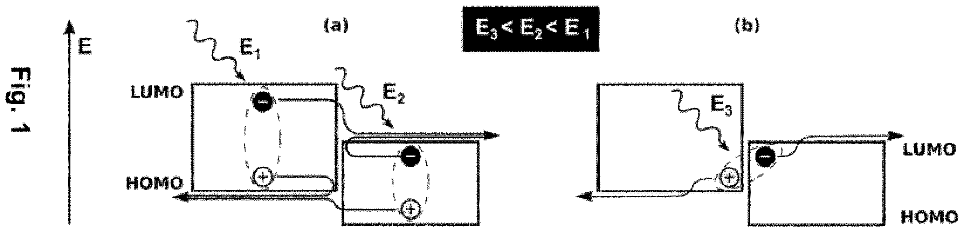

Unter Verweis auf Figur 1 (linke Darstellung) absorbieren zwei organische Verbindungen folglich nur Photonen mit den Energien E₁ bzw. E₂, die der Energie ihrer Bandlücke (Energiedifferenz zwischen der HOMO-Energie und der LUMO-Energie der jeweiligen Verbindung) entsprechen oder sie überschreiten. In einem zweiten Schritt kann die, in Folge der Absorption elektromagnetischer Strahlung angeregte, Verbindung nun entweder durch Rekombination in den Grundzustand übergehen oder die negative Ladung vom LUMO über einen interchromophoren Ladungstransfer auf das HOMO einer zweiten, als Akzeptor dienenden, Verbindung übertragen.

Dem gegenüber liegt im Sinne der vorliegenden Erfindung ein "direkter interchromophorer Ladungstransfer" vor, wenn die Absorption eines Photons mit der Energie E₃ an der Grenzfläche der Verbindung 1 und der Verbindung 2 zu einer direkten Übertragung eines Elektrons von dem HOMO (oder energetisch niedriger) der Verbindung 1 auf das LUMO (oder energetisch höher) der Verbindung 2 erfolgt und in Folge dessen zwischen der Verbindung 1 und der Verbindung 2 direkt ein gemeinsamer Ladungstransferzustand angeregt wird (vgl. Fig. 1, rechte Darstellung). Mithin ist die für den direkten interchromophoren Ladungstransfer benötigte Energie E₃ insbesondere bei Solarzellmaterialien kleiner als die der jeweiligen Bandlücke E₁ bzw. E₂.

Erfindungsgemäß liegt das Energieäquivalent des Wellenlängenbereichs des zu detektierenden elektromagnetischen Signals im Bereich von (i) der Energiedifferenz definiert durch die HOMO-Energie der Verbindung 1 und die LUMO-Energie der Verbindung 2 und (ii) der Energiedifferenz definiert durch die HOMO-Energie und die LUMO-Energie der Verbindung 1 (d.h. im Absorptionsbereich des direkten interchromophoren Ladungstransferzustandes zwischen Verbindung 1 und 2).

Dabei ist das Energieäquivalent einer Wellenlänge definiert als Photonenenergie E elektromagnetischer Strahlung, die gemäß folgender Gleichung einer Wellenlänge λ zugeordnet ist: E = h*c / λ, wobei h dem Planckschen Wirkungsquantum und c der Lichtgeschwindigkeit entspricht.

Der Begriff HOMO bezeichnet definitionsgemäß das höchste besetzte Molekülorbital (englisch highest occupied molecular orbital). Der Begriff LUMO bezeichnet definitionsgemäß das unterste unbesetzte Molekülorbital (englisch lowest unoccupied molecular orbital).

Die zwei sich funktionell gegenüberliegenden Spiegelflächen mit einem genau definierten Abstand im Mikrometerbereich bilden *eine "optische Mikrokavität"* aus.

Als Spiegelflächen eignen sich im Sinne der Erfindung insbesondere planar ausgebildete Grenzflächen, die plasmonische oder dielektrische Reflexion ausnutzen. Weiterhin vorteilhaft eignen sich mittels eines eindimensionalen Interferenzgitters höhenstrukturierte Grenzflächen (im Sinne verteilter Rückkopplung (englisch distributed feedback, kurz DFB)), die Total-Reflexion ausnutzen.

Erfindungsgemäß ist der Abstand der Spiegelflächen so zu wählen, dass die sich innerhalb der Spiegelanordnung ausbildende Resonanz-Wellenlänge in den Bereich der Absorption des direkten Ladungstransferzustandes fällt. Durch vorteilhafte Positionierung der photoaktiven Schicht innerhalb der Spiegel-Anordnung wird die Absorption des direkten interchromophoren Ladungstransferzustands gegenüber der Absorption in Schichtabfolgen ohne Spiegelflächen um einen Faktor im Bereich von 10 bis 10.000 verstärkt.

Vorzugsweise wird die, über die photoaktive Schicht gemittelte Intensität des einfallenden, zu detektierenden elektromagnetischen Signals durch das erfindungsgemäße Verfahren um den Faktor 10 bis 10000 verstärkt.

Um eine Resonanz-Wellenlänge der optischen Mikrokavität im Bereich der Absorption des direkten interchromophoren Ladungstransferzustands zu erzielen, entspricht die optische Weglänge zwischen den Spiegelflächen, umfassend alle durch die Mikrokavität eingeschlossenen Schichten, vorzugsweise der halben Wellenlänge der angestrebten direkten interchromophoren Ladungstransfer-Absorption. Dabei ergibt sich die optische Weglänge der Mikrokavität als Produkt der geometrischen Weglänge und des Brechungsindexes des Mediums aufsummiert über alle sich zwischen den Spiegelflächen befindlichen Einzelschichten. Weiterhin weist der Wert für die angestrebte optische Weglänge, bspw. aufgrund plasmonischer Effekte, eine Toleranz im Bereich von ±50% auf. Im Spezialfall einer strukturierten Spiegelfläche (im Sinne eines Interferenzgitters gemäß einer Spiegelfläche mit verteilter Rückkopplung (englisch distributed feedback oder kurz DFB)) ist die Resonanz-Bedingung nach einer dem Fachmann bekannten zwei- bzw. dreidimensionalen Gesetzmäßigkeit anzupassen.

Trifft elektromagnetische Strahlung der Resonanz-Wellenlänge (elektromagnetische Strahlung mit längster Wellenlänge, die die konstruktive Interferenz-Bedingung in einer optischen Mikrokavität erfüllt) auf die Kavität, wird das einfallende elektromagnetische Signal vorteilhaft mehrfach zwischen den beiden Spiegelflächen reflektiert, so dass das optische Feld dieser Resonanz-Wellenlänge vorteilhaft verstärkt wird. Gleichzeitig wird Licht, welches nicht der Resonanz-Wellenlänge entspricht, bereits vor Eintritt in die optische Mikrokavität reflektiert.

Im Sinne der vorliegenden Erfindung wird unter dem Begriff der "Resonanz-Wellenlänge" die Wellenlänge des zu detektierenden elektromagnetischen Signals verstanden, die der optischen Weglänge zwischen den Spiegelflächen im Bereich von 25 bis 75% entspricht und die höchste Feldverstärkung aufweist.

Bei den Spiegelflächen handelt es sich definitionsgemäß um die beiden Grenzflächen, die für das Ausbilden der optischen Mikrokavität verantwortlich sind, d.h. die abgrenzenden Grenzflächen zweier benachbarter Medien mit unterschiedlichem Brechungsindex.

Das die Spiegelfläche berührende, der optischen Mikrokavität abgewandte Medium wird im Folgenden erfindungsgemäß als Spiegelmedium bezeichnet. Handelt es sich dabei weiterhin um einen Festkörper (bspw. ein organo-basiertes oder oxidisches Spiegelmedium), wird im Folgenden erfindungsgemäß der Begriff der Spiegelschicht verwendet.

Die Resonanz-Wellenlänge, beruhend auf dem geometrischen Abstand der Spiegelfläche sowie gegebenenfalls dem Eindringen des optischen Feldes in die Spiegelschicht, befindet sich im Bereich zwischen 10 nm und 10 µm gemäß der konstruktiven Interferenz-Bedingung.

Konstruktive Interferenz (d.h. Verstärkung des zu detektierenden elektromagnetischen Signals durch Reflexion innerhalb der optischen Mikrokavität) erfolgt durch vorteilhaftes Überlagern des optischen Feldes bei einer definierten Wellenlänge. Voraussetzung für eine konstruktive Interferenz ist das Aneinandergrenzen zweier benachbarter Medien, wobei die Medien einen unterschiedlichen Brechungsindex aufweisen, so dass sich zwischen diesen Medien eine Spiegelfläche ausbildet. Im eindimensionalen Fall tritt die konstruktive Interferenz-Bedingung ein, wenn die optische Weglänge zwischen den Spiegelflächen im Bereich von 25% bis 75% der Wellenlänge des zu detektierenden Signals entspricht, ganz besonders bevorzugt der halben Wellenlänge des zu detektierenden Signals entspricht. Allerdings führen bspw. plasmonische Effekte zu Abweichungen der vorgenannten Vorschrift im Bereich von ±50%.

Die Feldverstärkung ist im Sinne der Erfindung definiert als spektral abhängiges Verhältnis des optischen Feldes mit zum optischen Feld ohne Ausnutzung von konstruktiver Interferenz.

Nach einer bevorzugten Ausgestaltung der vorliegenden Erfindung sind die zwei sich gegenüberliegenden Spiegelflächen planparallel zueinander angeordnet.

Vorzugsweise weisen die zwei sich gegenüberliegenden Spiegelflächen einen definierten geometrischen Abstand im Bereich von 100 bis 5000 nm, besonders bevorzugt 200 bis 1000 nm, zueinander auf.

Alternativ bevorzugt sind die zwei sich gegenüberliegenden Spiegelflächen gekippt mit einer Varianz des geometrischen Abstandes im Bereich von 1 bis 500 nm, vorzugsweise 10 bis 100 nm, zueinander angeordnet, wobei der mittlere geometrische Abstand der beiden Spiegelflächen zueinander im Bereich von 100 bis 5000 nm, besonders bevorzugt 200 bis 1000 nm, liegt. Besonders vorteilhaft erlaubt die Varianz des Abstandes der Spiegelflächen eine spektroskopische Untersuchung der einfallenden elektromagnetischen Strahlung, wobei die Elektroden mehrstückig (d.h. als Array) ausgebildet und je mit einer separaten Auslese-Einheit verbunden sind.

Vorzugsweise ist jedes Medium im Sinne der Erfindung als Einzelschicht oder Schichtabfolge ausgebildet.

Vorzugsweise ist die Spiegelfläche planar ausgebildet, wenn das Spiegelmedium metallische Reflexion mittels Plasmonen oder dielektrische Reflexion im Zusammenhang mit konstruktiver Interferenz (bspw. dielektrische Spiegelschicht (englisch distributed Bragg reflector (DBR)) ausnutzt.

Im Zusammenhang metallischer Reflexion mittels Plasmonen speziell im Hinblick auf den Einsatz im infraroten Wellenlängenbereich sind als Spiegelschicht insbesondere geeignet: Silber (Ag, insbesondere geeignet ab einer Wellenlänge der Bestrahlung von 350 nm), Gold (Au, insbesondere geeignet ab 700 nm) und Aluminium (Al, insbesondere geeignet ab 1500 nm).

Im Zusammenhang dielektrischer Reflexion und konstruktiver Interferenz, das heißt DBR-Spiegelschicht, ist das Spiegelmedium als eine Schichtabfolge mit abwechselnd hohem und niedrigem Brechungsindex ausgebildet. Als Materialien mit niedrigem Brechungsindex kommen insbesondere Siliziumdioxid (SiO₂, geeignet im Wellenlängenbereich 250 nm bis 5000 nm) oder Metallfluoride, insbesondere Alkali-, Erdalkali- oder Seltenerdmetallfluoride, bspw. Lithiumfluorid (LiF) oder Lanthanfluorid (LaF₃), in Betracht. Als Material mit einem hohen Brechungsindex kommen insbesondere kostengünstige Metalloxide, ausgewählt aus Titandioxid (TiO₂, geeignet im Wellenlängenbereich 450 nm bis 2500 nm), Aluminiumoxid (Al₂O₃, geeignet bis 1600nm), Zirconium(IV)-oxid (ZrO₂, geeignet ab 400 nm)) sowie Sulfide wie Zinksulfid (ZnS, geeignet ab 800 nm) in Betracht. Des Weiteren eignen sich die Metalloxide Tantal(V)-oxid (Ta₂O₅, geeignet im Wellenlängenbereich 300 nm bis 1750 nm), Hafniumdioxid (HfO₂, geeignet im Wellenlängenbereich von 350 nm bis 800 nm) sowie Nitride, wie bspw. Aluminiumnitrid (AIN, geeignet im Wellenlängenbereich zwischen 500 nm und 5000 nm), sowie II-VI-Verbindungshalbleiter wie Zinkselenid (kurz ZnSe). Die Einzelschichten der DBR-Struktur weisen dabei optische Schichtdicken auf, die einem Viertel der Resonanz-Wellenlänge der optischen Mikrokavität entsprechen.

Nach einer alternativen Ausführungsform der Erfindung wird eine Spiegelfläche mittels einer auf Total-Reflexion basierenden DFB-Spiegelschicht realisiert, das heißt mittels einer lateralen Höhenstrukturierung (etwa mittels einer Photolackschicht), wobei vorzugsweise eine laterale Periodizität zwischen 100 nm und 10 µm mit einer Gitteramplitude zwischen 1 nm und 100 nm zu wählen ist. In dieser Ausführungsform entspricht die substratferne (d.h. die dem Substrat entferntere) Spiegelfläche der obersten Grenzfläche des optoelektronischen Bauelements. Dabei liegt der Brechungsindex des Spiegelmediums unterhalb aller sich innerhalb der optischen Mikrokavität befindlichen Schichten.

Als substratnahes (d.h. das dem Substrat nächstliegende) Spiegelmedium eignet sich insbesondere ein mit einer Photolackschicht (zum Beispiel ma-P1210 von micro resist technology GmbH) strukturiertes Substrat, etwa aus Glas oder Kunststoff. Als substratfernes Spiegelmedium eignet sich insbesondere eine Barriereschicht, wie Aluminiumoxid (Al₂O₃), oder inertes Gas wie Stickstoff.

Vorteilhaft erfolgt durch die optische Mikrokavität des optoelektronischen Bauelements eine schmalbandige Verstärkung (d.h. Verstärkung für ein Wellenlängenintervall um die Resonanz-Wellenlänge) der absorbierten elektromagnetischen Strahlung. Diese Verstärkung zeichnet sich durch eine Halbwertsbreite der Externen Quanteneffizienz (EQE) bzw. der spektralen Antwort von kleiner 50 nm, besonders bevorzugt von kleiner 10 nm, aus. Durch die gleichzeitige Durchstimmbarkeit (d.h. gezieltes Variieren) der Resonanz-Wellenlänge, bspw. mittels Schichtdickenvariation der optischen Abstandshalterschichten, sind durch das erfindungsgemäße Verfahren besonders vorteilhaft spektroskopische Anwendungen bzw. Multiplexing (d.h. simultane Datenerfassung/-verarbeitung mehrerer Wellenlängen) möglich.

Gleichwohl zeichnet sich das erfindungsgemäße Verfahren dadurch aus, dass gegenüber der herkömmlichen Singulett-Anregung einer Verbindung über deren Bandlücke nur sehr geringe Energien, vorzugsweise im Wellenlängenbereich von 780 nm bis 1 µm, für die Anregung des gemeinsamen direkten interchromophoren Ladungstransferzustands erforderlich sind, wodurch vorteilhaft organische Verbindungen mit ihrerseits großer Bandlücke eingesetzt werden können. Da keine im sichtbaren Bereich absorbierenden Verbindungen (d.h. mit großer Bandlücke) für das erfindungsgemäße Verfahren erforderlich sind, können die Einzel-Verbindungen des erfindungsgemäß zur Detektion eines Infrarotsignals eingesetzten optoelektronischen Bauelements vorteilhaft unempfindlich (d.h. keine Anregung und kein elektrisches Signal) gegenüber dem sichtbaren Wellenlängenbereich ausgebildet sein.

Bevorzugt sind die Verbindungen 1 und 2 unempfindlich gegenüber elektromagnetischer Strahlung aus dem sichtbaren Wellenlängenbereich.

Vorzugsweise ist das erfindungsgemäß eingesetzte optoelektronische Bauelement (bspw. der Detektor) für elektromagnetische Strahlung im sichtbaren Wellenlängenbereich teilweise oder vollständig transparent gestaltet. Dadurch wird zugleich vorteilhaft die Funktions-Lebensdauer der photoaktiven Schicht vergrößert.

Vorzugsweise zeichnet sich das erfindungsgemäß eingesetzte optoelektronische Bauelement durch geringe Ströme der Dunkelkennlinien in der Größenordnung 10 nA/cm² aus.

Weiterhin bevorzugt weist das erfindungsgemäß eingesetzte optoelektronische Bauelement eine EQE vorzugsweise zwischen 10% und 80% unter Kurzschluss-Bedingungen für Wellenlängen von 780 nm bis 1000 nm bzw. eine EQE größer 0,5% für höhere Wellenlängen im Infrarotbereich auf.

Abgeleitet aus der vorgenannten EQE ergibt sich für das erfindungsgemäß eingesetzte optoelektronische Bauelement eine spektrale Antwort vorzugsweise in der Größenordnung von 0,01 bis 0,1 A/W unter Kurzschluss-Bedingungen im Wellenlängenbereich 780 nm bis 1000 nm bzw. für höhere Wellenlängen im Infrarotbereich 0,001 bis 0,1 A/W.

Vorzugsweise weist das erfindungsgemäß eingesetzte optoelektronische Bauelement eine spezifische Detektivität im Wellenlängenbereich 780 nm bis 1000 nm in der Größenordnung 10¹¹ bis 10¹² Jones unter Kurzschluss-Bedingungen bzw. für höhere Wellenlängen im Infrarotbereich eine spezifische Detektivität mindestens in der Größenordnung von 10⁹ Jones auf.

Auch charakteristisch ist für das erfindungsgemäß eingesetzte optoelektronische Bauelement ein An-Aus-Verhältnis des Photostroms zum Dunkelstrom im Wellenlängenbereich 780 nm bis 1000 nm in der Größenordnung 10⁴ bis 10⁵ unter Kurzschluss-Bedingungen bei einer entsprechenden Bestrahlung mittels Nah-Infrarot in der Größenordnung von 1 mW/cm².

Dem Fachmann ist bekannt, dass mit dem erfindungsgemäßen Verfahren grundsätzlich elektromagnetische Strahlung im Bereich von Ultraviolett bis Infrarot detektiert werden kann. Besonders vorteilhaft eignet sich das erfindungsgemäße Verfahren zur Detektion elektromagnetischer Strahlung im Wellenlängenbereich (Spektralbereich) von 780 nm bis 10 µm. Besonders bevorzugt eignet sich das erfindungsgemäße Verfahren zur Detektion von elektromagnetischer Strahlung im nahen und/oder mittleren Infrarotbereich von 780 bis 50000 nm, ganz besonders bevorzugt im nahen Infrarotbereich (NIR-Bereich) von 780 bis 3000 nm nach DIN 5031.

Das zu detektierende elektromagnetische Signal stellt im Sinne der Erfindung einen spektralen Ausschnitt aus der Gesamtheit der einfallenden elektromagnetischen Strahlung dar. Insbesondere reagiert der Detektor sensitiv auf ein schmales Intervall um die zu detektierende Resonanz-Wellenlänge. Dabei weist die externe Quanteneffizienz des erfindungsgemäßen Detektors eine Halbwertsbreite von weniger als 50 nm, bevorzugt von weniger als 10 nm, auf.

Besonders bevorzugt sind die beiden Verbindungen 1 und 2 in der photoaktiven Schicht ausgewählt aus der Gruppe der niedermolekularen (vorzugsweise vakuumprozessierbaren) organischen Verbindungen oder aus der Gruppe der Polymere (vorzugsweise aus Lösung prozessierbar) oder Fullerene.

Im Sinne der vorliegenden Erfindung ist die photoaktive Schicht als dreidimensionale Schicht innerhalb der optischen Mikrokavität ausgebildet, in der die Detektionswellenlänge elektromagnetischer Strahlung im Absorptionsbereich des direkten interchromophoren Ladungstransferzustands liegt und dessen Energie anschließend in schwach gebundene oder freie Ladungsträger überführt wird.

Erfolgt das Aufbringen der photoaktiven Schicht mittels Vakuumprozessierung, ist die Verbindung 1 (Elektronendonor) vorzugsweise ausgewählt aus der Stoffgruppe der Phthalocyanine (wie Zinkphthalocyanin oder Eisenphthalocyanin), der Pyrane, bspw. Bispyraniliden (abgekürzt auch TPDP), der Fulvalene, bspw. Tetrathiofulvalen (abgekürzt auch OMTTF) sowie der aromatischen Amine (bspw. N,N,N',N'-Tetrakis(4-methoxyphenyl)-benzidine (abgekürzt auch MeO-TPD), 2,7-Bis[N,N-bis(4-methoxy-phenyl)amino]9,9-spiro-bifluorene (abgekürzt auch Spiro-MeO-TPD) oder 4,4',4"-Tris(3-methylphenyl-phenylamino)triphenylamin (abgekürzt auch m-MTDATA)), der Bisthiopyranilidene, der Bipyridinylidene oder der Diketopyrrolopyrrole.

Erfolgt das Aufbringen der photoaktiven Schicht mittels Flüssigprozessierung, ist die Verbindung 1 vorzugsweise ausgewählt aus der Stoffgruppe der Polythiophene (bspw. etwa poly(2,5-bis(3-alkylthiophene-2- yl)thieno[3,2-b]thiophene (abgekürzt auch pBTTT)).

Im Falle eines Polymeres zeichnet sich Verbindung 1 vorzugsweise derart aus, dass der räumliche Abstand der Seitenketten der räumlichen Ausdehnung von Verbindung 2 (Elektronenakzeptor) entspricht, so dass sich durch das systematische Einlagern der Verbindung 2 in die Zwischenräume der Seitenketten von Verbindung 1 Bikristalle (wie beschrieben in N. C. Miller et al., Adv. Energy Mater. 2012, 2, 1208, DOI: 10.1002/aenm.201200392) ausbilden. Die dadurch vergrößerte Donor-Akzeptor-Oberfläche führt hierbei vorteilhaft zu erhöhter Absorption des interchromophoren Ladungstransferzustandes.

Bevorzugt ist die Verbindung 2 (Elektronenakzeptor) im Rahmen des Aufbringens der photoaktiven Schicht mittels Vakuumprozessierung ausgewählt aus der Stoffgruppe der Fullerene, bspw. C60.

Erfolgt das Aufbringen der photoaktiven Schicht mittels Flüssigprozessierung, ist die Verbindung 2 vorzugsweise Phenyl-C61-Buttersäuremethylester (kurz PCBM) oder Poly-(2,5-Bis(3- Tetradecylthiophen-2-yl)thieno[3,2-b]thiophen) (kurz PBTTT- C14).

Nach einer bevorzugten Ausgestaltung der vorliegenden Erfindung können die Verbindung 1 und die Verbindung 2 miteinander kovalent, bspw. über einen Linker (flexible Abstandshalter) verbunden sein. Derartige Linker sind dem Fachmann bekannt und sind insbesondere ausgewählt aus der Stoffgruppe der C1-C12-Alkylgruppen, C1-C12-Alkenylgruppen, C1-C12-Alkoxygruppen, C1-C12-Polyalkoxygruppen, aliphatische oder zyklische Diamine und zyklischer bzw. polyzyklischer Arylgruppen. Bevorzugt sind die Linker über eine reaktive Kopplungsgruppe (funktionelle Gruppe) an die Verbindung 1 bzw. 2 gebunden. Vorzugsweise ist die reaktive Kopplungsgruppe eine Aminogruppe (-NH₂), Thiolgruppe (-SH), Alkoholgruppe (-OH), Amidgruppe (-C(=O)NH₂)), Trichlorsilylgruppe (-SiCl3) oder Carboxylgruppen (-C(=O)OH)).

Bevorzugt ist das Substrat steif, teilsteif oder flexibel.

Es ist insbesondere zweckdienlich, dass das Substrat transparent ist. Derartige Substrate sind dem Fachmann bekannt und bspw. ausgewählt aus transparenten Substraten, wie bspw. Glas, Kunststoff (Polyethylenterephthalat (kurz PET), etc.), einem Metallband oder einem Metallmischoxid (bspw. Indiumzinnoxid) oder Mischschichten daraus. Das Substrat kann eben oder gekrümmt sein.

Nach einer bevorzugten Ausgestaltung der vorliegenden Erfindung sind innerhalb der optischen Mikrokavität zwei optische Abstandshalterschichten angeordnet.

Besonders vorteilhaft lässt sich durch die Dicke der optischen Abstandshalterschichten die Resonanz-Wellenlänge der optischen Mikrokavität in dem erfindungsgemäßen optoelektronischen Bauelement im Bereich des sichtbaren Lichts, nahen Ultraviolett- (UV) oder IR-Bereich einstellen.

Die beiden optischen Abstandshalterschichten innerhalb der optischen Mikrokavität dienen dazu a) die Resonanz-Wellenlänge der optischen Mikrokavität in den Absorptionsbereich des direkten interchromophoren Ladungstransferzustandes zu legen und b) die photoaktive Schicht im räumlichen Intensitätsmaximum der Resonanz-Wellenlänge innerhalb der optischen Mikrokavität auszurichten.

Das räumliche Intensitätsmaximum ist definiert als das spektral aufgelöste Maximum der räumlichen Intensitätsverteilung des optischen Feldes.

Zum gezielten Adressieren einer vorgegebenen Resonanz-Wellenlänge sind die Dicken der optischen Abstandshalterschichten so gewählt, dass die optische Weglänge zwischen den Spiegelflächen im Bereich von 25 bis 75% der Wellenlänge des zu detektierenden Signals entspricht, ganz besonders bevorzugt der halben Wellenlänge des zu detektierenden Signals entspricht, allerdings führen bspw. plasmonische Effekte zu Abweichungen der vorgenannten Vorschrift im Bereich von ±50%.

Als im Sinne der Erfindung zweckdienlich erweisen sich optische Abstandshalterschichten, die in planparalleler Anordnung der Spiegelflächen einen geometrischen Abstand der Spiegelflächen zwischen 100 nm und 5000 nm, bevorzugt zwischen 200 und 1000 nm, erzeugen.

In verkippter Anordnung der beiden sich gegenüberliegenden Spiegelflächen erzeugen die optischen Abstandshalter eine Varianz des geometrischen Abstandes beider Spiegelflächen im Bereich von 1 bis 500 nm, vorzugsweise 10 bis 100 nm. Der mittlere geometrische Abstand der beiden Spiegelflächen, den die optischen Abstandshalterschichten erzeugen, liegt im Bereich von 100 bis 5000 nm, besonders bevorzugt 200 bis 1000 nm. Besonders vorteilhaft erlaubt die Varianz des Abstandes der Spiegelflächen eine spektroskopische Untersuchung der einfallenden elektromagnetischen Strahlung, wobei die Elektroden mehrstückig (d.h. als Array) ausgebildet und je mit einer separaten Auslese-Einheit verbunden sind.

Als Materialien für die optischen Abstandshalterschichten eignen sich Materialien, die glatt aufwachsen (die Schicht weist vorzugsweise eine globale Dickenvariation kleiner 5 nm, vorzugsweise kleiner 2 nm auf) sowie einen Brechungsindex aufweisen, der höchstens so groß wie die Maxima der Brechungsindizes aller sonstigen, sich zwischen den Spiegelflächen befindlichen Schichten ist. Weiterhin weisen die optischen Abstandshalterschichten bezüglich der zu detektierenden Wellenlänge eine Absorption kleiner 0,1%, vorzugsweise kleiner 0,01%, auf. Dafür eignen sich organische Halbleiter, beispielsweise sowohl kleine Moleküle, die mittels Vakuumprozessierung oder Flüssigprozessierung aufgebracht werden, wie etwa aromatische Amine (wie N,N,N',N'-Tetrakis(4-methoxyphenyl)-benzidine (abgekürzt auch MeO-TPD), 2,7-Bis[N,N-bis(4-methoxy-phenyl)amino]9,9-spiro-bifluorene (abgekürzt auch Spiro-MeO-TPD) oder N4,N4'-bis(9,9-dimethyl-9H-fluoren-2-yl)-N4,N4'-diphenylbiphenyl-4,4'-diamine (abgekürzt auch BF-DPB) oder 9,9-bis[4-(N,N-bis-biphenyl-4-yl-amino)phenyl]-9H-fluorene (abgekürzt auch BPAPF)), als auch Polymere, die mittels Flüssigprozessierung aufgebracht werden, wie etwa Poly-3,4-ethylendioxythiophen Poly(Styrenesulfonat (kurz PEDOT:PSS), oder Oxide wie Siliziumoxid (abgekürzt SiO2).

Nach einer bevorzugten Ausgestaltung der vorliegenden Erfindung sind die optischen Abstandshalterschichten als elektronenleitende oder löcherleitende Transportschicht ausgebildet.

Nach einer weiteren bevorzugten Ausgestaltung der vorliegenden Erfindung sind die optischen Abstandshalterschichten als optischer Filter für elektromagnetische Strahlung aus dem sichtbaren Wellenlängenbereich ausgebildet. Wellenlängen aus diesem Bereich werden statt in der photoaktiven Schicht in der optischen Abstandshalterschicht absorbiert, wo sie nicht zum Photostrom des optoelektronischen Bauelementes beitragen (wie für Infrarotdetektoren häufig erwünscht). In diesem Zusammenhang besteht die optische Abstandshalterschicht beispielsweise aus der Verbindung 1 oder Verbindung 2 (mit einem Schichtanteil von mindestens 80 Massenprozent).

Es kann zweckdienlich sein, dass elektronleitende bzw. löcherleitende Transportschichten eine n- bzw. p-Dotierung im Bereich von 1 bis 50 Massenprozent (abgekürzt Ma.-%) aufweisen. Bevorzugt weisen die Transportschichten eine n- bzw. p-Dotierung im Bereich von 1 bis 25 Ma.-%, besonders bevorzugt von 1 bis 10 Ma.-% auf. Ma.-% bezieht sich definitionsgemäß auf die Gesamtzusammensetzung der Transportschicht.

Dabei bezeichnet "n"- bzw. "p"-Dotierung das Einbringen freibeweglicher negativer bzw. positiver Ladungen in die elektronenleitende oder löcherleitende Transportschicht, was in einer Erhöhung der freien Elektronendichte bzw. Löcherdichte der entsprechend dotierten Transportschicht im thermodynamischen Gleichgewichtszustand resultiert.

Eine Ausführungsform der vorliegenden Erfindung zeichnet sich dadurch aus, dass als n-Dotandenprecursor oder n-Dotierungsagenz ein heterocyclisches Radikal oder Diradikal, deren Dimere, Oligomere, Polymere, Metallocene (etwa Cobaltocen), Alkalimetalle wie Cäsium, Paddlewheel-Komplexe (wie etwa von Wolfram, Molybdän oder von Chrom), Dispiroverbindungen und Polycyclen oder Leukobasen von Farbstoffen eingesetzt werden. Als p-Dotanden eignen sich etwa Tetracyanochinodimethane, Lewissäuren, Radialene, Dithiolat-Übergangsmetallkomplexe oder Fluor-substituierte Fullerene. Derartige Dotandenprecursor oder Dotierungsagenzien sind dem Fachmann bestens bekannt.

Als Matrixmoleküle eignen sich Materialien mit Energieangleich des Transportniveaus zwischen photoaktiver Schicht und der Transportschicht. Somit bietet sich als Matrix der elektronenleitenden optischen Abstandshalterschicht erneut die Verbindung 2, das heißt Fullerene, bzw. auch als Matrix der löcherleitenden Transportschicht die Verbindung 1 an. Des Weiteren eignen sich als Matrix der löcherleitenden Transportschicht die Klasse der aromatischen Amine (bspw. N,N,N',N'-Tetrakis(4-methoxyphenyl)-benzidine (abgekürzt auch MeO-TPD), 2,7-Bis[N,N-bis(4-methoxy-phenyl)amino]9,9-spiro-bifluorene (abgekürzt auch Spiro-MeO-TPD) oder N4,N4'-bis(9,9-dimethyl-9H-fluoren-2-yl)-N4,N4'-diphenylbiphenyl-4,4'-diamine (abgekürzt auch BF-DPB) oder 9,9-bis[4-(N,N-bis-biphenyl-4-yl-amino)phenyl]-9H-fluorene (abgekürzt auch BPAPF)).

Des Weiteren eignen sich als Matrix der elektronenleitenden Transportschicht die Klasse der Chinoline (wie etwa tris(8-hydroxy-quinolinato)-aluminium (abgekürzt auch Alq3)), der Phenanthroline (wie etwa 4,7-diphenyl-1,10-phenanthroline (abgekürzt auch Bphen), der Trinaphthylene (wie etwa 2,3,8,9,14,15-Hexafluoro-5,6,11,12,17,18-hexaaza-trinaphthylene (abgekürzt auch HATNA-F6)) oder Naphthalendiimide (wie etwa N,N-Bis(fluoren-2-yl)-naphthalenetetracarboxylic diimide (abgekürzt auch Bis-Hfl-NTCDI)).

Der Anteil des vom optoelektronischen Bauelement ausgegebenen elektrischen Signales, der sich auf die Bestrahlung desselben mit einem elektromagnetischen Signal zurückführen lässt, ergibt sich als:
Iₚₕₒₜₒ = I_{ES} - I_{dunkel}, wobei die Größen Iₚₕₒₜₒ dem Photostrom, I_{ES} dem elektrischen Signal (d.h. dem Strom unter Beleuchtung) sowie I_{dunkel} dem Strom ohne Beleuchtung entsprechen. Alle drei Größen hängen von einer gegebenenfalls angelegten externen Spannung ab.

Vorzugsweise wird das elektrische Signal, welches aus der Umwandlung des elektromagnetischen Signals erhalten wird, mittels Elektroden und einer Auslese-Einheit vermessen. Vorteilhaft erlaubt das Auslesen des elektrischen Signals eine Weiterverarbeitung mit einer nachgeschalteten, dem Fachmann bekannten Elektronik.

Gegebenenfalls wird das Auslesen des Stroms aus dem optoelektronischen Bauelement durch das Anlegen einer externen Spannung unterstützt, welche typischerweise im Bereich zwischen 0 und -100 V liegt. Besonders vorteilhaft wird durch das Anlegen der externen Spannung die externe Quanteneffizienz des optoelektronischen Bauelements im Detektionsbereich gesteigert und die Reaktionszeit (Anstiegszeit des Photostroms bei Erreichen der Detektionswellenlänge im Detektor) verkürzt.

Vorteilhaft zeichnet sich das erfindungsgemäße optoelektronische Bauelement gegenüber dem aus dem Stand der Technik bekannten Bauelement durch die Detektion von Wellenlängen oberhalb 1000 nm aus, wobei die Durchstimmbarkeit der Resonanz-Wellenlänge und die geringe Halbwertsbreite der EQE (bzw. der spektralen Antwort) die Verwendung des erfindungsgemäßen optoelektronischen Bauelements als Spektrometer ermöglichen.

Insbesondere vorteilhaft ermöglicht eine geeignete Wahl der Verbindungen 1 und 2 in der aktiven Schicht einen breiten Absorptionsbereich des direkten interchromophoren Ladungstransferzustandes, einhergehend mit freier Wahl der Wellenlänge des zu detektierenden Signals innerhalb dieses Bereichs.

Gegenstand der vorliegenden Erfindung ist auch ein optoelektronisches Bauelement auf einem Substrat, vorzugsweise zur Verwendung in einem erfindungsgemäßen Verfahren, aufweisend zumindest:
i. zwei voneinander beabstandete und sich gegenüberliegende Spiegelflächen, die eine optische Mikrokavität ausbilden,
ii. eine zwischen den Spiegelflächen angeordnete photoaktive Schicht, enthaltend mindestens eine Verbindung 1 und eine Verbindung 2,
wobei die Energiedifferenz zwischen der HOMO-Energie der Verbindung 1 und der LUMO-Energie der Verbindung 2 unterhalb 1.6 eV liegt,
wobei die optische Weglänge zwischen den Spiegelflächen im Bereich von 25% bis 75% der Wellenlänge des zu detektierenden Signals entspricht und
wobei das Energieäquivalent des Wellenlängenbereichs des zu detektierenden elektromagnetischen Signals im Bereich von
- der Energiedifferenz definiert durch die HOMO-Energie der Verbindung 1 und die LUMO-Energie der Verbindung 2 und
- der Energiedifferenz definiert durch die HOMO-Energie und die LUMO-Energie der Verbindung 1 liegt,
wobei die photoaktive Schicht innerhalb der optischen Mikrokavität im räumlichen Intensitätsmaximum der Wellenlänge des zu detektierenden elektromagnetischen Signals zwischen den Spiegelflächen ausgerichtet ist.

Im Sinne der vorliegenden Erfindung ist das optoelektronische Bauelement als Infrarot-Detektor, Solarzelle bzw. als deren Komponente ausgebildet. Im Sinne der Erfindung ist ein Detektor als photosensitives, optoelektronisches Bauelement zum Bereitstellen des größtmöglichen Photostroms durch Umwandlung der zu detektierenden elektromagnetischen Umgebungsstrahlung unter der Randbedingung eines möglichst kleinen Dunkelstromes optimiert.

Eine Solarzelle ist im Sinne der vorliegenden Erfindung ein energieautarkes, photosensitives, optoelektronisches Bauelement, das zum Bereitstellen der größtmöglichen elektrischen Leistung durch Umwandlung des Sonnenlichtes optimiert ist. Dabei wird zum Ausrichten der photoaktiven Schichten bezüglich der Wellenlänge mit maximaler Extinktion im Bereich der Singulett-Absorption vorzugsweise die konstruktive Interferenz-Bedingung genutzt.

Da im Sinne der Erfindung keine im sichtbaren Wellenlängenbereich absorbierenden Verbindungen erforderlich sind, ist das erfindungsgemäße optoelektronische Bauelement, insbesondere bei der Verwendung als Infrarot-Detektor, vorzugsweise im sichtbaren Wellenlängenbereich transparent oder zumindest teiltransparent ausgebildet. Teiltransparent ist ein Material im Sinne der Erfindung, wenn im sichtbaren Wellenlängenbereich mindestens 30% der Strahlung transmittiert werden.

Nach einer bevorzugten Ausgestaltung der vorliegenden Erfindung weist das erfindungsgemäße Bauelement eine Auslese-Einheit zum Auslesen des elektrischen Signals auf.

Vorzugsweise dient die Auslese-Einheit auch zur Weiterverarbeitung des ausgelesenen elektrischen Signals.

Nach einer bevorzugten Ausgestaltung der vorliegenden Erfindung weist das optoelektronische Bauelement mindestens zwei voneinander beabstandete Elektroden auf, die als Elektrodenpaar (d.h. Anode und Katode) ausgebildet sind.

Nach einer bevorzugten Ausgestaltung der vorliegenden Erfindung weist das Material, aus dem die Elektrode besteht, eine hohe Leitfähigkeit auf. Fungiert eine auf Metall basierende Spiegelschicht gleichzeitig als Elektrode, weist diese vorzugsweise eine Reflektivität zwischen 80% und 100%, bevorzugt zwischen 95% und 100%, besonders bevorzugt zwischen 99% und 100%, auf, wobei das Material bspw. aus Silber, Aluminium und Gold ausgewählt ist.

Andernfalls soll die Elektrode eine hohe Transparenz, das heißt Extinktionskoeffizienten zwischen 0 und 10⁻², bevorzugt zwischen 0 und 10⁻³ und besonders bevorzugt zwischen 0 und 10⁻⁴, aufweisen. In diesem Zusammenhang eignen sich etwa dotierte Metalloxide wie Indiumzinnoxid (kurz ITO) oder Aluminium-Zinkoxid (abgekürzt AZO), hochleitfähige, glatt aufwachsende kleine Moleküle (etwa durch Dotieren wie etwa C60 dotiert mit tetrakis(1,3,4,6,7,8-hexahydro-2H-pyrimido[1,2-a]pyrimidinato)-ditungsten (II) (kurz Wpd, 16 Massenprozent Dotierung)) oder hochleitfähige, glatt aufwachsende Polymere wie etwa Poly-3,4-ethylendioxythiophen Poly(Styrenesulfonat) (kurz PEDOT:PSS) oder aber Graphen.

Es kann vorgesehen sein, dass zumindest eine Elektrode mehrstückig (d.h. als Array) ausgebildet ist. Durch die array-artig angeordneten Elektrodensegmente liegen vorteilhaft mehrere Messbereiche in dem optoelektronischen Bauelement vor, die jeweils separat durch eine Auslese-Einheit ausgelesen werden. Dies ermöglicht einerseits eine räumliche Auflösung (bspw. für den Einsatz in einer Kamera mit IR-Detektor) eines einstrahlenden zu detektierenden elektromagnetischen Signals, wobei die beiden Spiegelflächen in dieser Ausführung planparallel angeordnet sind. Andererseits ermöglichen array-artig angeordnete Elektrodensegmente eine spektrale Auflösung im Sinne eines Spektrometers durch eine zueinander gekippte Anordnung der Spiegelflächen, so dass jedem Elektrodensegment eine andere Resonanz-Wellenlänge zugeordnet ist, wodurch sich vorteilhaft das zu detektierende elektromagnetische Signal pro Elektrodensegment unterscheidet.

Optional weist das optoelektronische Bauelement optische Filterschichten zum Reduzieren eines ungewünschten Photostroms, wie er bspw. aus exzitonischer Absorption resultiert, auf. So kann einfallende elektromagnetische Strahlung im sichtbaren Wellenlängenbereich, besonders doppelte oder höhere Ordnungen der Resonanz-Wellenlänge, hinsichtlich eines Beitrags zum Photostroms vorteilhaft unterdrückt werden. Bevorzugt sind die optischen Filterschichten innerhalb oder außerhalb der optischen Mikrokavität eingesetzt. Als optische Filterschichten eignen sich organische Materialien mit Extinktionskoeffizienten zwischen 0,2 und 3,0 für ein Wellenlängenintervall zwischen 75 nm und 600 nm, wie die Perylene (etwa P4-2,3,10,11-tetrapropyl-1,4,9,12-tetraphenyl-diindeno[1,2,3-cd:1',2',3'-Im]perylene (P4-Ph4-DIP)), die Phthalocyanine (etwa ZnPc) und/oder die Oligothiophene (etwa 2,2'-((3",4"-dimethyl-[2,2':5',2":5",2''':5''',2''''-quinquethiophene]-5,5''''-diyl)bis(methanylylidene))-dimalononitrile (kurz DCVST-Me(3,3)) jeweils als reine, ungemischte Schicht.

Auch kann vorgesehen sein, dass das optoelektronische Bauelement Ladungsträger-Blockierschichten aufweist, die vorteilhaft den Transport eines freien Ladungsträgers zur unvorteilhaften Elektrode unterbinden. Vorteilhaft wird dies durch Materialien erreicht, die eine große Bandlücke aufweisen. Nach einer bevorzugten Ausgestaltung der Erfindung wird die Funktion der Ladungsträger-Blockierschicht durch die Matrixmaterialien der Transportschichten mit übernommen.

Optional weist das optoelektronische Bauelement Barriereschichten bzw. eine Verkapselung auf, die das Eindringen im Sinne der Leistungsfähigkeit des optoelektronischen Bauelements schädlicher Umwelteinflüsse (wie etwa Sauerstoff oder Wasser) unterdrückt. Erfindungsgemäß sind die Barriereschichten in Abstimmung mit dem Substrat steif (etwa Glas), teilsteif oder flexibel (etwa Dünnschichtverkapselung mittels Atomlagenabscheidung (englisch Atomic Layer Deposition, kurz ALD) vorzugsweise von Oxiden (etwa Molybdänoxid) oder mittels Metallen (etwa Aluminium) oder Organik (wie etwa tris(8-hydroxy-quinolinato)-aluminium (Alq3))) ausgestaltet.

Weiterhin optional weist das optoelektronische Bauelement Zwischenschichten zum glatten Aufwachsen (so genannte Keimschichten) der Folgeschichten durch Materialien mit hoher Oberflächenenergie, wie etwa Gold oder Titan, oder Diffusionsbarrieren, etwa Zwischenlagen unedlerer Metalle, wie Aluminium, oder Oxide, wie Molybdänoxid, für darüber liegende edlere Metalle auf.

Neben der Detektion einer einzelnen Wellenlänge, bei planparalleler Anordnung der zwei sich gegenüberliegenden Spiegelflächen, sind auch spektroskopische Anwendungen im dargelegten Wellenlängenbereich wünschenswert. Daher besteht die Aufgabe gemäß eines zweiten Aspekts der vorliegenden Erfindung darin, ein Spektrometer bereitzustellen.

Die spektrale Auflösung des zu detektierenden elektromagnetischen Signals wird gemäß einer bevorzugten Ausgestaltung der Erfindung dadurch erreicht, dass der geometrische Abstand der zwei sich gegenüberliegenden Spiegelflächen eines erfindungsgemäßen optoelektronischen Bauelements in mindestens einer lateralen Richtung, also in einer Richtung parallel zur Oberfläche des Substrats, auf der das optoelektronische Bauelement angeordnet ist, variiert. Durch Variation des geometrischen Abstands der zwei Spiegelflächen wird die optische Weglänge zwischen den Spiegelflächen variiert und damit die Resonanz-Wellenlänge der optischen Mikrokavität verändert.

Dabei kann der geometrische Abstand der Spiegelflächen zum einen kontinuierlich variieren, indem die beiden Spiegelflächen gekippt unter Variation der optischen Kavitätsschichtdicke zur Auflösung der Detektionswellenlänge über laterale Verschiebung im Sinne eines Spektrometers zueinander angeordnet werden.

Liegen die Spiegelflächen gekippt zueinander vor, so liegt erfindungsgemäß in der Ebene des Substrates ein Gradient der Resonanz-Wellenlänge vor, wobei alle in der optischen Mikrokavität vorliegenden Resonanz-Wellenlängen im Bereich der Absorption des direkten interchromophoren Ladungstransferzustandes und deren Energieäquivalente unterhalb der Singulett-Absorption der Verbindung 1 (Elektronendonor) liegen.

Liegen die Spiegelflächen gekippt zueinander vor, ist die Elektrode mehrstückig (d.h. als Array) ausgebildet, wobei gleich viele elektrisch entkoppelte Auslese-Einheiten zum Auslesen des Photostroms angeschlossen sind.

Zum anderen kann der geometrische Abstand der Spiegelflächen diskontinuierlich, also stufenförmig in diskreten Abstufungen, variieren. Eine diskontinuierliche Varianz des geometrischen Abstands der Spiegelflächen ergibt sich daraus, dass das optoelektronische Bauelement elektrisch voneinander isolierte Segmente aufweist, innerhalb derer die zwei sich gegenüberliegenden Spiegelflächen planparallel angeordnet sind. Benachbarte Segmente weisen unterschiedliche geometrische Abstände der zwei sich gegenüberliegenden Spiegelflächen auf. Der geometrische Abstand der Spiegelflächen variiert also segmentweise. Das optoelektronische Bauelement weist damit eine laterale Strukturierung, also eine Strukturierung in mindestens einer Richtung parallel zur Oberfläche des Substrats, auf der das optoelektronische Bauelement angeordnet ist, auf. Die Strukturierung kann auch in zwei lateralen Richtungen in Form von Pixeln erfolgen. Dabei ist in jedem Pixel eine optische Mikrokavität mit einer bestimmten Resonanz-Wellenlänge ausgebildet, so dass jedem Pixel eine bestimmte Detektionswellenlänge im Bereich der Absorption des direkten interchromophoren Ladungstransferzustandes zugeordnet werden kann.

Die oben erwähnte, kontinuierliche oder diskontinuierliche, Variation der optischen Kavitätsschichtdicke erfolgt bevorzugt über die Schichtdickenvariation der optischen Abstandshalterschichten.

Weiterhin besteht die Möglichkeit, zusätzlich oder stattdessen die Schichtdickenvariation über die Dicke der photoaktiven Schicht und/oder anderer Schichten, wie etwa der Elektrodendicke oder organischer Schichten, einzustellen.

Neben den bereits aufgezählten Möglichkeiten ermöglicht das Verkippen des optoelektronischen Bauelements um einen Neigungswinkel im Bereich von 0 bis 90 Grad bezüglich des einstrahlenden, zu detektierenden elektromagnetischen Signals im Gesamten ebenfalls eine Variation der Resonanz-Wellenlänge.

Nach einer bevorzugten Ausgestaltung der vorliegenden Erfindung werden das erfindungsgemäße Verfahren und das erfindungsgemäße optoelektronische Bauelement zum zeitaufgelösten Auslesen der Telekommunikation über Lichtwellenleiter verwendet. Besonders vorteilhaft ermöglicht das erfindungsgemäße Verfahren und der erfindungsgemäße Aufbau des optoelektronischen Bauelements das simultane Auslesen mehrerer Wellenlängen (Multiplexing). Relevante Wellenlängen sind hierbei bspw. 850 nm, 1310 nm und 1550 nm.

In einer alternativen Ausgestaltung der vorliegenden Erfindung werden das erfindungsgemäße Verfahren und das erfindungsgemäße optoelektronische Bauelement zum zeitaufgelösten Auslesen kurzreichweitiger Drahtloskommunikation, insbesondere von Mobilgeräten, wie bspw. Mobiltelefongeräten oder stationären Geräten, wie bspw. Empfänger einer Fernbedienung oder eines Computers, verwendet.

Nach einer besonders bevorzugten Ausgestaltung der vorliegenden Erfindung finden das erfindungsgemäße Verfahren und das erfindungsgemäße optoelektronische Bauelement Verwendung für das Erfassen von Bewegung (Bewegungsmelder etwa im Sinne von Sicherheitstechnik oder Computerspielen), Abstand (Abstandsmesser etwa im Sinne von Virtual Reality) oder der Position (etwa Lichtschranke oder Triangulation mittels mehrerer Empfänger).

Des Weiteren erfahren das erfindungsgemäße Verfahren und das erfindungsgemäße optoelektronische Bauelement Verwendung für die räumliche Auflösung von infraroter Strahlung, wie bspw. im Sinne von Infrarot-Fotografie, Detektion nahinfrarot-sensitiver Sicherheitsmerkmale, wie bspw. bei Pässen, oder zerstörungsfreien Analysen etwa von Kunstobjekten (wie bspw. historische Gemälde) hinsichtlich unterliegender Schichten.

In einer alternativen Ausgestaltung der vorliegenden Erfindung wird das erfindungsgemäße Verfahren zur energieautarken Bereitstellung elektrischer Leistung durch Umwandlung des infraroten Anteils des Sonnenspektrums im Sinne einer Solarzelle oder als Bestandteil dieser eingesetzt.

Darüber hinaus dient das erfindungsgemäße optoelektronische Bauelement zur Herstellung eines Spektrometers im Nahinfrarot-Bereich mit den oben genannten Eigenschaften. Anwendungssituationen für ein derartiges Spektrometer sind insbesondere:
i) das Aufnehmen des Spektrums im Nahinfrarot-Bereich;
ii) die Bestimmung der Probenzusammensetzung einer analythaltigen Probe anhand von Absorptionsbanden, die charakteristisch für bestimmte Molekülbindungen sind;
iii) das Multiplexing zum simultanen Auslesen verschiedener Wellenlängen im Rahmen Lichtwellenleiter-gestützter Telekommunikation;
iv) die medizinische Diagnostik, wie bspw. die Messung des Blutzuckers oder des Sauerstoffgehaltes im Blut (Pulsoxymetrie, Vergleich Transmission zweier Wellenlängen) oder bspw. in den Neurowissenschaften als bildgebendes Verfahren zum zerstörungsfreien Untersuchen des Gehirns oder von Geweben, oder für urologische Untersuchungen der Harnblase;
v) die Qualitätskontrolle von landwirtschaftlichen und/oder leicht verderblichen Erzeugnissen, etwa zum Bestimmen des Gehaltes an Wasser, Proteinen, Fett oder Kunststoffen;
vi) die Qualitätskontrolle von chemischen und pharmazeutischen Produkten sowie der Petrochemie
vii) Infrarot-Astronomie;
viii) als Gehirn-Computer-Schnittstelle, bspw. für Patienten mit Locked-in-Syndrom.

### Ausführungsbeispiele

Die vorbenannten erfindungsgemäßen Ausführungsformen sind geeignet, die Aufgabe zu lösen. Dabei sind auch Kombinationen der offenbarten Ausführungsformen zur Lösung der Aufgabe geeignet. Bevorzugte Weiterbildungen der Erfindung ergeben sich aus den Kombinationen der Ansprüche oder einzelner Merkmale davon.

Nachfolgend soll die Erfindung anhand einiger Ausführungsbeispiele und der zugehörigen Figur eingehender erläutert werden. Die Ausführungsbeispiele sollen die Erfindung beschreiben, wobei die Erfindung nicht auf die Ausführungsbeispiele beschränkt ist.

Dabei zeigt:
- Fig. 1: eine Darstellung verschiedener Absorptionsmechanismen im Rahmen organischer Halbleiter sowie anschließender Extraktion der Ladungsträger. Die linke Darstellung (a) zeigt die herkömmliche Singulett-Absorption der *Einze*/materialien Die rechte Darstellung (b) zeigt die erfindungsgemäß genutzte Absorption des direkten interchromophoren Ladungstransferzustands.

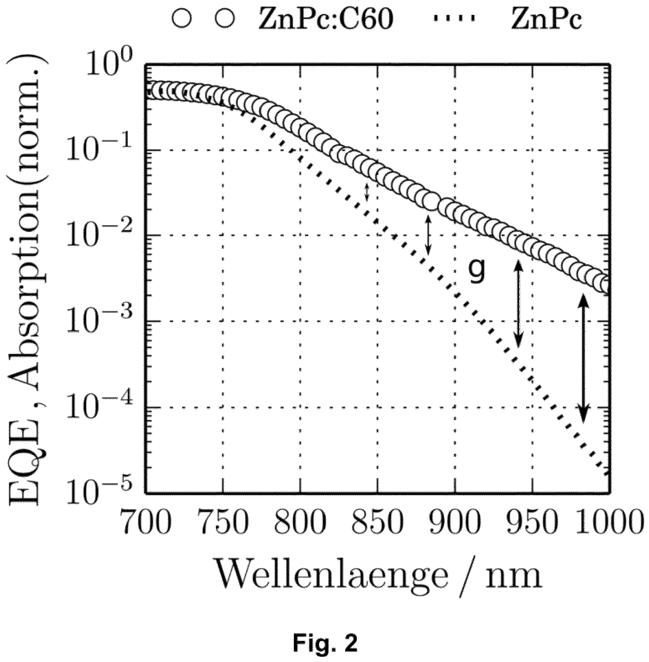

- Fig. 2: einen Vergleich des Absorptionsverhaltens einer reinen ZnPc-Schicht (l l l) in Gegenüberstellung zu einer ZnPc-C60-Mischschicht (o o o) als photoaktiver Schicht; gestrichelte Kennlinie (l l l): Fourier-Transformierte der Photostrom-Spektroskopie an einer reinen, ungemischten ZnPc-Schicht im Sinne einer hochauflösenden Absorptionsmessung; Kennlinie mit Kreisen (o o o): Externe Quanteneffizienz-Messung einer Solarzelle (d.h. Referenzzelle optimiert für eine Resonanz-Wellenlänge im sichtbaren Wellenlängenbereich) mit einer ZnPc:C60-Mischschicht (Mischungsverhältnis 1:1 Volumenanteil).

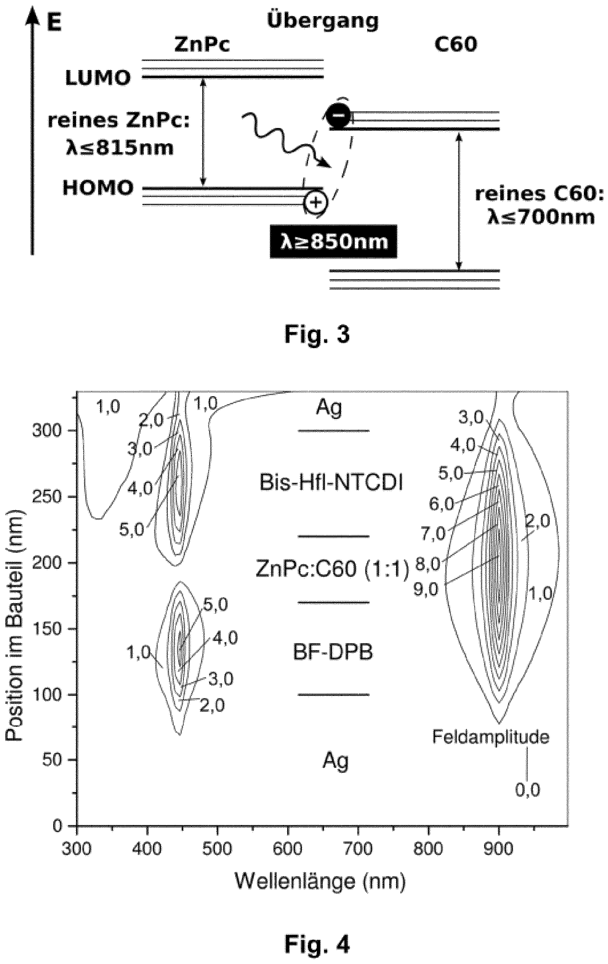

- Fig. 3: ein Schema der Energieniveaus von: links ZnPc, rechts C60, Mitte Übergang mit direktem interchromophoren Ladungstransferzustand.
- Fig. 4: die simulierte Amplitudenverteilung des optischen Feldes eines erfindungsgemäßen optoelektronischen Bauelementes aufgetragen über Position im Detektor und eingestrahlter Wellenlänge der eintretenden elektromagnetischen Strahlung. In der Mitte ist die Schichtabfolge samt Hilfslinien abgebildet.

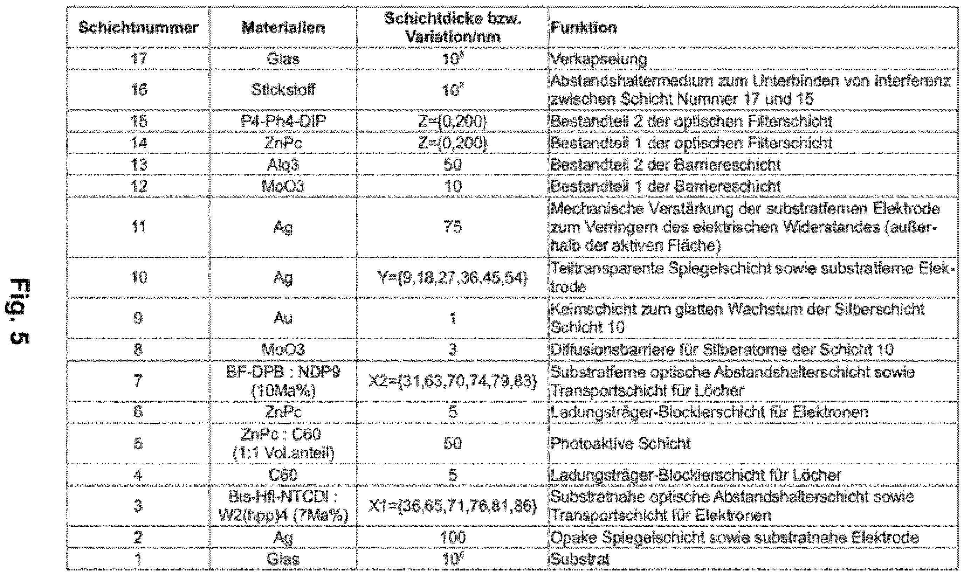

- Fig. 5: eine Übersicht von Nah-Infrarot-Detektoren, basierend auf der Absorption des direkten interchromophoren Ladungstransfers von ZnPc-C60-Mischschichten. Im Rahmen einer Schichtdickenvariation werden gleichzeitig die Dicken der optischen Abstandshalterschichten X1 und X2, die Dicken der transparenten Silber-Spiegelschicht Y sowie die Dicken der optischen Filterschicht Z variiert.

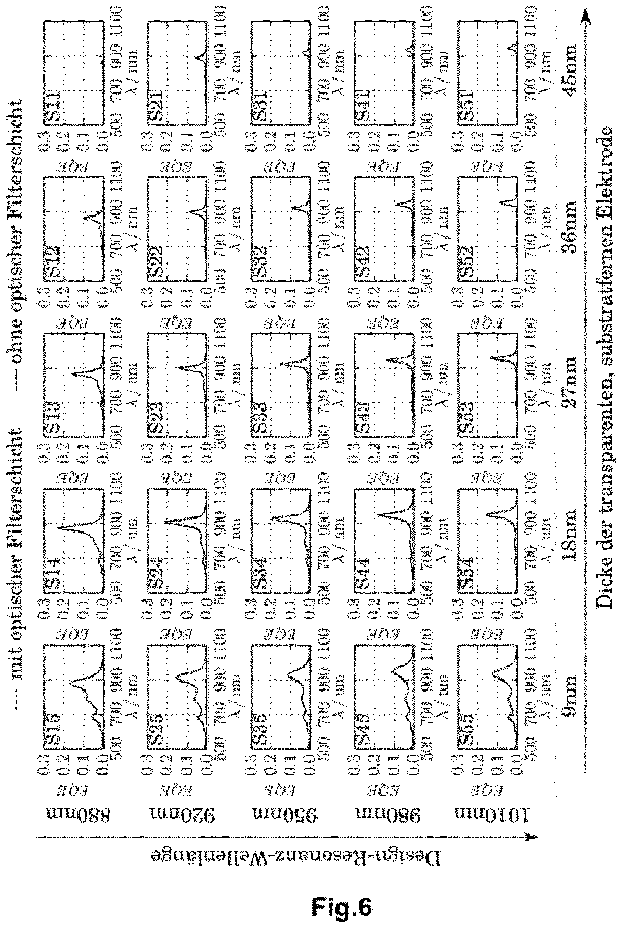

- Fig. 6: die Detektion elektromagnetischer Strahlung verschiedener Wellenlängen mithilfe des in Fig. 5 dargelegten Probensatzes, ausgedrückt in externer Quanteneffizienz (EQE).

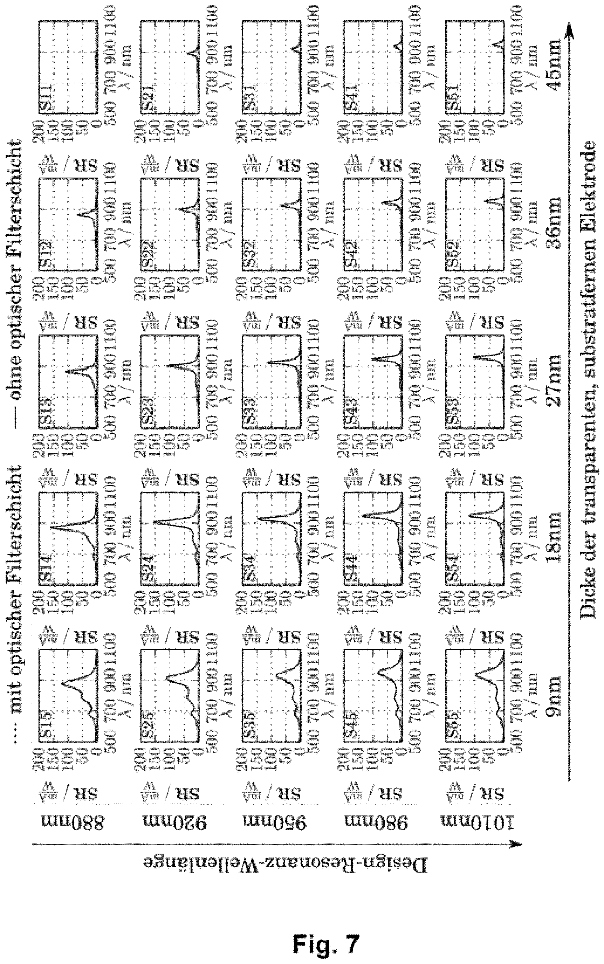

- Fig. 7: die Detektion elektromagnetischer Strahlung verschiedener Wellenlängen mithilfe des in Fig. 5 dargelegten Probensatzes, ausgedrückt in spektraler Antwort (SR).

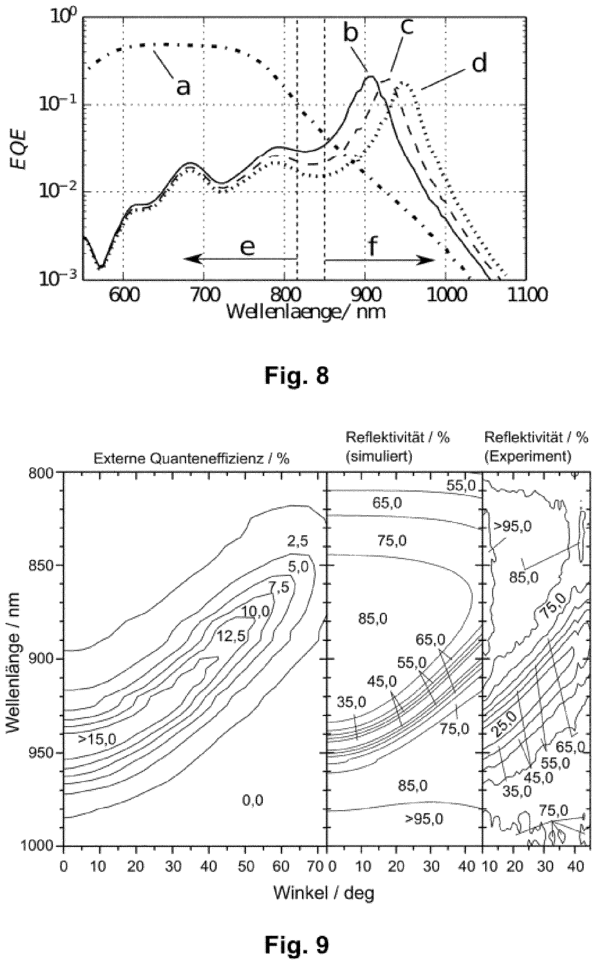

- Fig.8: die externe Quanteneffizienz verschiedener optoelektronischer, photosensitiver Bauelemente, für ausgewählte Proben aus dem Probensatz dargestellt in Fig. 5.
- Fig.9: die Winkelabhängigkeit eines erfindungsgemäßen, optoelektronischen Bauelementes bezüglich optischer und elektrischer Parameter. Links nach rechts: Abhängigkeit der experimentell gemessenen externen Quanteneffizienz; Abhängigkeit der simulierten Reflektivität; Abhängigkeit der experimentell gemessenen Reflektivität.

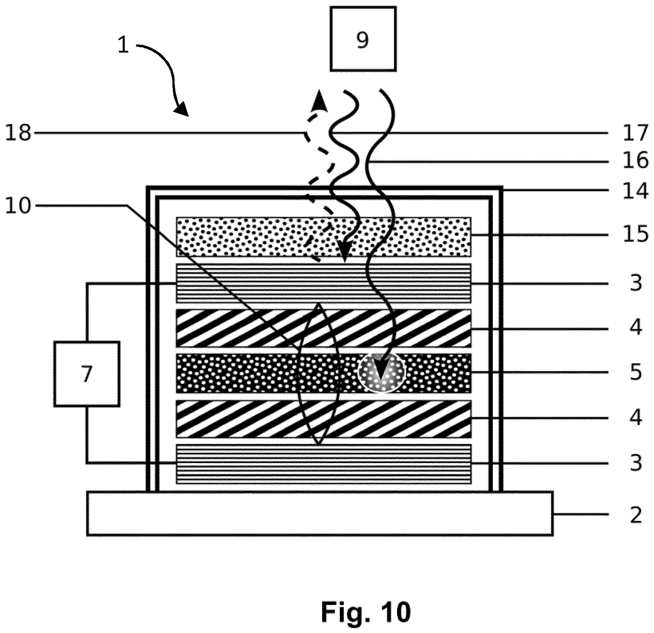

- Fig. 10: den schematischen Schichtaufbau eines erfindungsgemäßen optoelektronischen Bauelements, wobei die Spiegelschichten bzw. die optischen Abstandshalterschichten elektrisch leitfähig ausgebildet sind, so dass sie gleichzeitig als Elektrode bzw. Transportschichten fungieren. Die Spiegelflächen sind planparallel angeordnet.

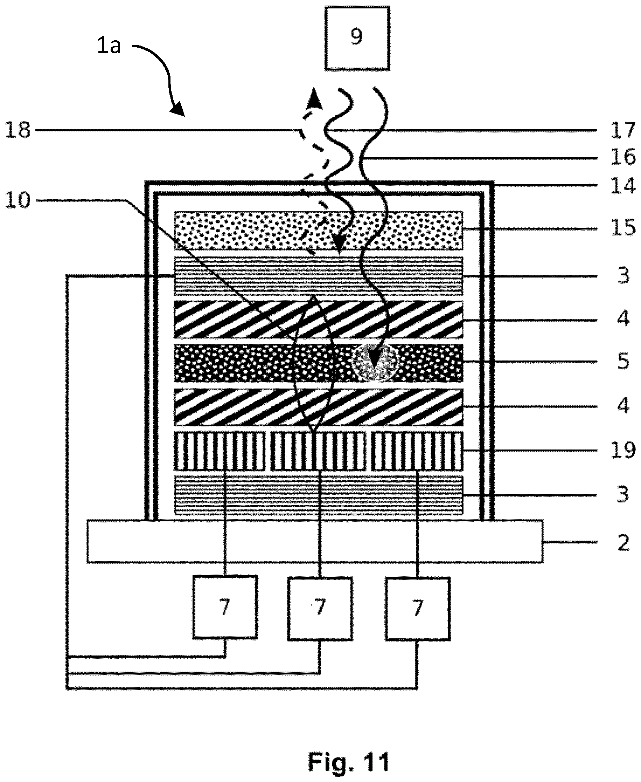

- Fig. 11: den schematischen Schichtaufbau eines erfindungsgemäßen optoelektronischen Bauelements wie in Fig. 10, wobei hier die Elektrode (19) segmentartig aufgeteilt und mit separaten Auslese-Einheiten versehen ist, so dass das eintreffende elektromagnetische Signal räumlich aufgelöst wird. Die Spiegelschicht ist in dieser Ausführung nicht elektrisch leitend ausgebildet.

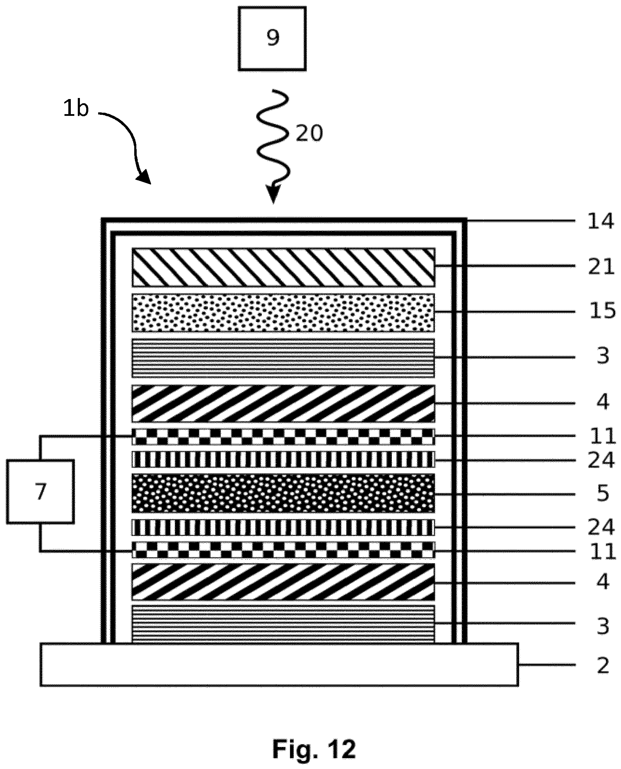

- Fig. 12: den schematischen Schichtaufbau eines erfindungsgemäßen optoelektronischen Bauelements, wobei im Vergleich zu Fig. 10 weder die Spiegelschichten noch die optischen Abstandshalterschichten elektrisch leitfähig ausgebildet sind. Stattdessen werden von den genannten Schichten räumlich getrennt Elektroden bzw. Transportschichten zur Verfügung gestellt.

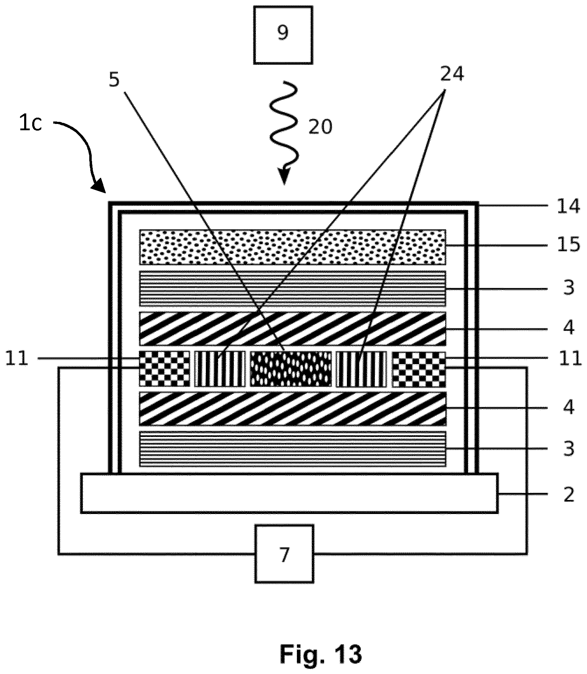

- Fig. 13: den schematischen Schichtaufbau eines erfindungsgemäßen optoelektronischen Bauelements, wobei im Vergleich zu Fig. 10 der Stromfluss parallel zum Substrat und damit senkrecht zum Lichteinfall erfolgt.

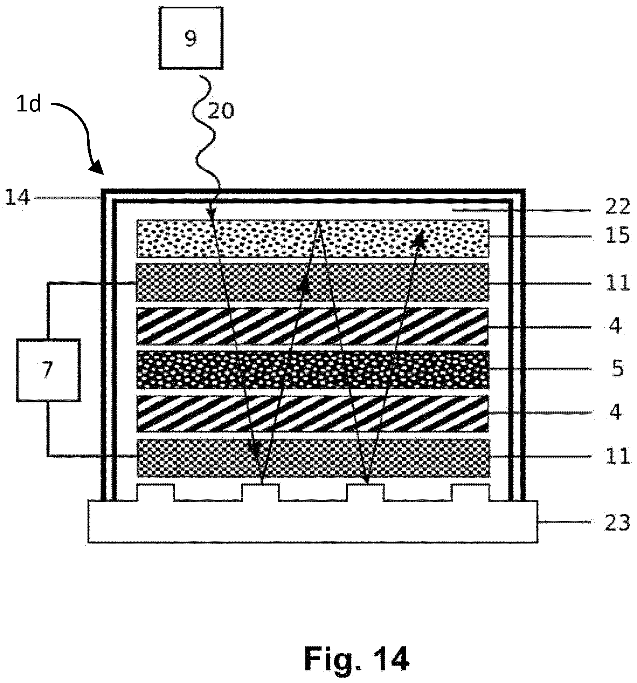

- Fig. 14: den schematischen Schichtaufbau eines erfindungsgemäßen optoelektronischen Bauelements, wobei im Gegensatz zu Fig. 10 die substratnahe Spiegelschicht als periodisches Interferenzgitter im Sinne verteilter Rückkopplung (DFB) ausgestaltet ist.

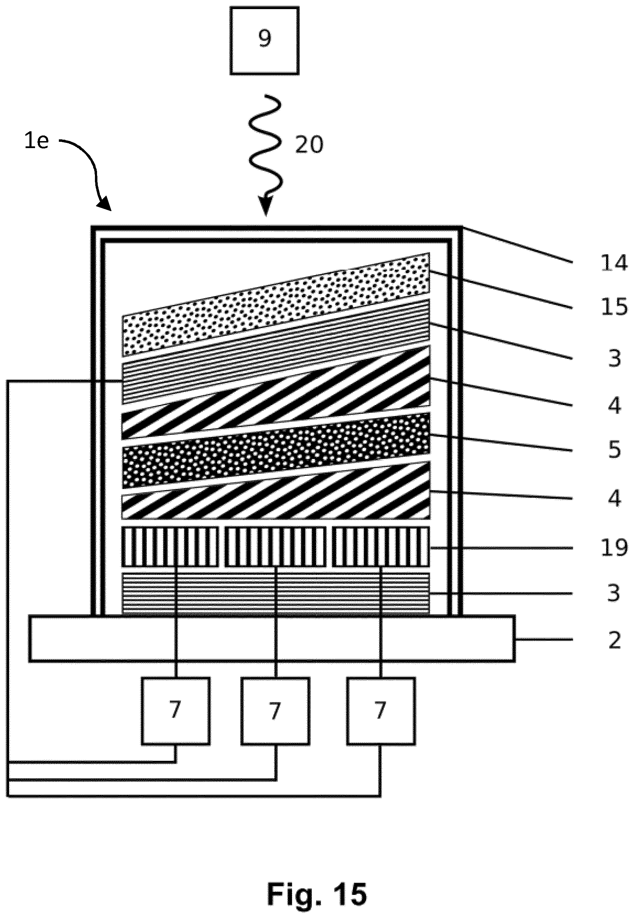

- Fig. 15: den schematischen Schichtaufbau eines erfindungsgemäßen optoelektronischen Bauelements, wobei im Vergleich zu Fig. 10 die Spiegelflächen zueinander verkippt sind sowie die substratnahe Elektrode segmentartig ausgeprägt ist, wodurch dieses Bauelement spektroskopische Untersuchungen ermöglicht.

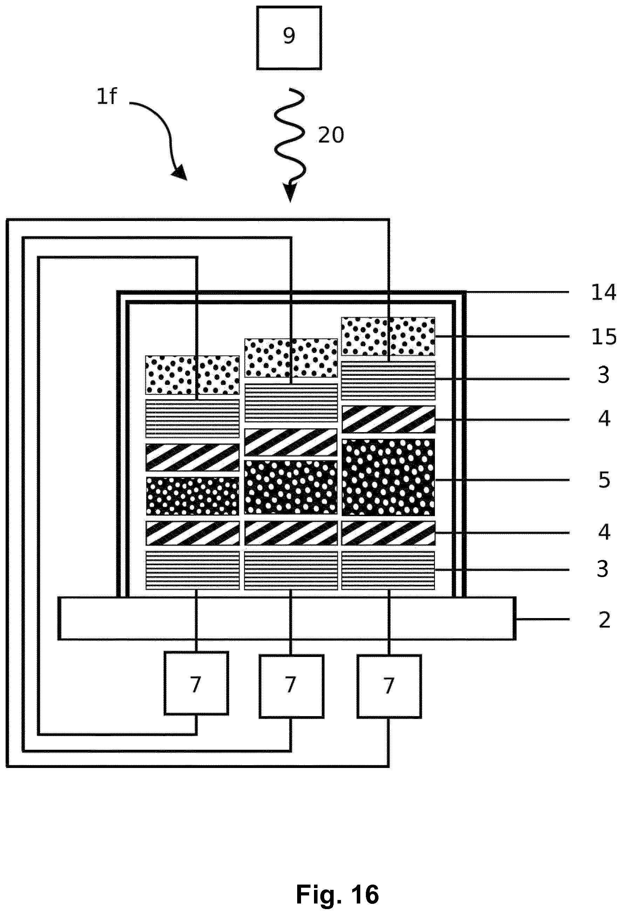

- Fig. 16: den schematischen Schichtaufbau eines erfindungsgemäßen optoelektronischen Bauelements, wobei im Vergleich zu Fig. 15 die Abstandsvariation der Spiegelflächen stufenartig erfolgt, und dieses Bauelement wiederum für spektroskopische Untersuchungen geeignet ist.

Fig. 1 zeigt eine Darstellung verschiedener Absorptionsmechanismen im Rahmen organischer Halbleiter sowie anschließender Extraktion der Ladungsträger. Die linke Darstellung (a) zeigt die herkömmliche Singulett-Absorption der Einzelmaterialien. Diese absorbieren Photonen der Energie E₁ bzw. E₂ oder höher. Zum Trennen und anschließendem Beitrag von Ladungsträgern zum Photostrom ist es erforderlich, dass das Coulomb-gebundene Ladungsträgerpaar (sog. Exziton) zunächst zur Grenzfläche beider Verbindungen diffundiert. Die rechte Darstellung Fig. 1(b) zeigt die erfindungsgemäß genutzte Absorption des direkten interchromophoren Ladungstransferzustands. An der Grenzfläche beider organischer Halbleiter wird ein Elektron aus dem HOMO der Verbindung 1 (Material mit höher gelegener HOMO-Energie) ins LUMO-Niveau der Verbindung 2 (Material mit niedrig gelegener LUMO-Energie) angehoben. Im Gegensatz zur linken Darstellung entfällt der Zwischenschritt der Exzitonendiffusion zur gemeinsamen Grenzfläche. Der direkte interchromophore Ladungstransfer-Zustand absorbiert Photonen der Energie E₃ (oder höher), wobei durch geeignete Wahl der Materialien E₃ kleiner als E₁ und E₂ gewählt werden kann, was günstig für Absorption im Infrarot-Bereich ist.

Die in Fig. 2 als photoaktive Schicht eingesetzte ZnPc:C60-Mischschicht weist für Wellenlängen größer als 750 nm eine höhere Absorption auf als die reine ZnPc-Schicht, wobei die Absorption der Mischschicht die der reinen Schicht oberhalb 900 nm um eine Größenordnung überschreitet. Die zusätzliche Absorption (siehe Bereich g in Fig. 2) stammt von der, durch die Grenzfläche zwischen beiden Farbstoffen ermöglichten, direkten Absorption des interchromophoren Ladungstransfer-Zustandes. Aufgrund der höheren optischen Bandlücke von C60 kann dessen Absorption oberhalb 700 nm vernachlässigt und deshalb auf die Absorption von C60 in dieser Abbildung verzichtet werden. Während das Absorptionssignal bei Wellenlängen unterhalb 850 nm vorrangig auf die Absorption des ZnPc-Singulett-Zustands zurückzuführen ist, absorbiert oberhalb vorrangig der direkte Ladungstransferzustand der ZnPc:C60-Mischschicht.

Wie aus Fig. 3 ersichtlich, absorbiert die reine C60- bzw. ZnPc-Schicht nur Photonen, deren Energie größer oder gleich der optischen Bandlücke ist. Für die reine C60-Schicht sind dies Wellenlängen kleiner oder gleich 700 nm, für die reine ZnPc-Schicht kleiner oder gleich 815 nm. Am Übergang der beiden organischen Halbleiter existiert neben dem Singulett-Zustand der Einzelmaterialien auch der direkte interchromophore Ladungstransferzustand. Dieser absorbiert Energien größer der Energiedifferenz der HOMO-Energie vom ZnPc und der LUMO-Energie von C60 und ermöglicht somit die Absorption von Wellenlängen größer als 850 nm.

Grundlage der in Fig. 4 dargestellten Berechnung ist das optoelektronische Bauelement: Glas (1 mm, Substrat) | Gold (2 nm) | Silber (28 nm, Spiegelschicht, die gleichzeitig als Elektrode fungiert) | N,N-Bis(fluoren-2-yl)-naphthalenetetracarboxylic diimide (kurz Bis-Hfl-NTCDI) dotiert mit tetrakis(1,3,4,6,7,8-hexahydro-2H-pyrimido[1,2-a]pyrimidinato)ditungsten (II) (kurz W2(hpp)4) (79 nm, 7 Ma.-%, optische Abstandshalterschicht, die gleichzeitig als elektronenleitende Transportschicht fungiert) Zink-Phthalocyanin (kurz ZnPc):C60 (50 nm,1:1, photoaktive Schicht) N,N'-((Diphenyl-N,N'-bis)9,9,-dimethyl-fluoren-2-yl)-benzidine (kurz BF-DPB) dotiert mit Novaled Dopant P-Side No. 9 (kurz NDP9) (71 nm, 10Ma.-%, optische Abstandshalterschicht, die gleichzeitig als löcherleitende Transportschicht fungiert) | Aluminium (1 nm) | Gold (2 nm) | Silber (100 nm, Spiegelschicht, die gleichzeitig als Elektrode fungiert) | Stickstoff (0,1 mm) | Kapselglas (1 mm), wobei der optische Einfluss des n-Dotanden im Rahmen der Simulation vernachlässigt wurde. Schichten mit einer Dicke kleiner als 3 nm wurden in der optischen Simulation berücksichtigt; auf deren Darstellung wurde in der Abbildung dennoch verzichtet. Die Grenzfläche zwischen BF-DPB und Silber (bei der Bauteilposition 100 nm) sowie die Grenzfläche zwischen Bis-Hfl-NTCDI und Silber (bei der Bauteilposition 303 nm) kennzeichnen die beiden Spiegelflächen in dem optoelektronischen Bauelement gemäß Fig. 4. Die *geometrische* Dicke von 203 nm entspricht in etwa 350 nm optischer Schichtdicke für eine Wellenlänge von 900 nm. Durch das partielle Eindringen des optischen Feldes in die Silber-Spiegelschicht dehnt sich das Feld nun auf ca. 450 nm aus.

Somit ist die konstruktive Interferenz-Bedingung für 900 nm (optische Weglänge entspricht halber Resonanz-Wellenlänge) erfüllt. Es entsteht eine stehende Welle mit maximaler Feldintensität in der photoaktiven Schicht (d.h. in der ZnPc:C60-Mischschicht). Weiterhin weist das konkrete Bauteil bei der halben Resonanz-Wellenlänge (ca. 455 nm) ein Intensitätsminimum des optischen Feldes in der photoaktiven Schicht auf.

Die Schichtdickenvariation X1 und X2 (die Schichtnummern 3 und 7 betreffend), wie in Fig. 5 dargestellt, ermöglicht eine Variation der Detektor-Wellenlänge bzw. Resonanz-Wellenlänge im Sinne eines Spektrometers. Mittels einer simultanen Variation der Schichtdicken der optischen Abstandshalterschichten (X1, X2) wird die Resonanz-Wellenlänge der optischen Mikrokavität vorteilhaft durchgestimmt, so dass sich a) unterschiedliche Resonanz-Wellenlängen ausbilden, und b) sich gleichzeitig die photoaktive Schicht im Intensitätsmaximum der optischen Feldverteilung (bezogen auf die Resonanz-Wellenlänge) befindet. Aufgrund eines geringfügig größeren Brechungsindexes der Matrix der Löchertransportschicht (BF-DPB) im Nahinfraroten im Vergleich zur Matrix der Elektronen-Transportschicht Bis-Hfl-NTCDI sind die Dicken der Löchertransportschicht systematisch größer gewählt, um die photoaktive Schicht im Maximum des optischen Feldes bezogen auf die Resonanz-Wellenlänge zu positionieren. Bezogen auf die substratferne teiltransparente Silber-Spiegelschicht (Schichtnummer 10) der Dicke 36 nm ergibt die Simulation gemäß der Variation X1 und X2 entsprechend folgende Resonanz-Wellenlängen: {605 nm, 880 nm, 920 nm, 950 nm, 980 nm, 1010 nm}. Die erste Resonanz-Wellenlänge 605 nm dient zum Vergleich mit regulären Solarzellen und ist nicht im Sinne der Erfindung aufzufassen. Die Schichtdickenvariation Y dient zum Optimieren der teiltransparenten Silber-Spiegelschicht in Hinblick auf eine hohe externe Quanteneffizienz sowie dem Unterdrücken aller Wellenlängen verschieden der Resonanz-Wellenlänge. Die Schichtdickenvariation Z dient zum Erproben optischer Filterschichten, die den Photostrom-Beitrag aus dem sichtbaren Wellenlängenbereich unterdrücken.

Wie aus Fig. 6 und Fig. 7 ersichtlich, ist die experimentell gemessene Resonanz-Wellenlänge eine monoton steigende Funktion der simulierten Resonanz-Wellenlänge, was die Durchstimmbarkeit der Detektor-Wellenlänge belegt. Eine Schichtdicke der transparenten Silber-Spiegelschicht zwischen 27 nm und 36 nm erzeugt innerhalb der Variation die leistungsfähigsten Detektoren hinsichtlich der EQE. Weiterhin erweisen sich die optischen Filterschichten als vorteilhaft im Hinblick auf Detektoren, die auf Wellenlängen verschieden der Resonanz-Wellenlänge unempfindlich sind.

Fig. 8 zeigt ausgewählte EQE-Messungen aus Fig. 6 mit ZnPc:C60 als photoaktive Schicht unter Variation der Resonanz-Wellenlänge. Fig. 8(a) zeigt die EQE eines als Solarzelle optimierten Bauteils (Referenzzelle) mit Resonanz-Wellenlänge im sichtbaren Wellenlängenbereich bei 700 nm zur effizienten Singulett-Absorption von ZnPc (Verbindung 1).

Dafür werden hinsichtlich der optischen Abstandshalterschichten folgende Schichtdicken gewählt: X1 = 36 nm und X2 = 31 nm. Weiterhin wird eine dünne Schichtdicke für die teiltransparente Silber-Spiegelschicht gewählt, um optisch der Absorption ohne Anwesenheit der Spiegelflächen (d.h. interferenzfrei) möglichst nahe zu kommen: Y = 9 nm. Weiterhin wird auf die optischen Filterschichten verzichtet: Z = 0 nm. Diese Probe dient zum Vergleich von Detektoren mit einer regulären Solarzelle und ist nicht im Sinne der Erfindung aufzufassen. Fig. 8(b)-(d) zeigt die Variation der Resonanz-Wellenlänge im Bereich der Absorption des direkten interchromophoren Ladungstransferzustands im Sinne eines Spektrometers. Für (b), (c), (d) gelten jeweils Y = 18 nm und Z = 200 nm, weiterhin für (a) X1 = 71 nm, X2 = 70 nm mit experimenteller Resonanz-Wellenlänge von 910 nm, für (b) X1 = 76 nm, X2 = 74 nm mit experimenteller Resonanz-Wellenlänge von 930 nm und für (c) X1 = 81 nm, X2 = 79 nm mit experimenteller Resonanz-Wellenlänge von 950 nm.

Der Fig. 9 liegt folgende Probenstruktur zu Grunde: Glas (1 mm) | Ag (100 nm) | Bis-Hfl-NTCDI:W2 (hpp)4 (81 nm,7 Ma.-%) | C60 (5 nm) | ZnPc:C60 (50 nm, 1:1 Vol.anteil) |ZnPc (5 nm) | BF-DPB:NDP9 (79 nm, 10Ma.-%) | MoO₃ (3 nm) | Au (1 nm) | Ag (18 nm) | Ag (75 nm) | | MoO₃ (10 nm) | | Alq3 (50 nm) | ZnPc (200 nm) | P4-Ph4-DIP (200 nm) | Stickstoff (0,1 mm) | Glas (1 mm). Die konstruktive Interferenzbedingung der optischen Mikrokavität drückt sich durch eine hohe Absorption und geringe Reflexion eintreffender Strahlung der Resonanz-Wellenlänge aus. In der simulierten Reflektivität beschreibt die Resonanz-Wellenlänge aufgrund der konstruktiven Interferenz-Bedingung eine Parabel. Dieses Verhalten bestätigen die experimentell gemessene Reflektivität sowie das elektrische Bauteil-Verhalten, demonstriert anhand der Externen Quanteneffizienz. Für Wellenlängen kleiner 850 nm fällt die Reflexion erneut ab: Optische Filterschichten außerhalb der optischen Mikrokavität reduzieren das optische Feld im sichtbaren Bereich innerhalb der optischen Mikrokavität. Somit ist der Detektor großteils unempfindlich gegenüber sichtbarem Licht.

Der Fig. 10 ist ein erfindungsgemäßes optoelektronisches Bauelement (1) zu entnehmen, welches die folgende Schichtabfolge aufweist: Substrat (2) aus Glas, Spiegelschicht (3) aus Silber (die gleichzeitig als Elektrode fungiert), eine optische Abstandshalterschicht (4) bestehend aus n-dotiertem Bis-Hfl-NTCDI (die gleichzeitig als Transportschicht für Elektronen dient), eine photoaktive Schicht (5) bestehend aus einer ZnPc:C60-Mischschicht (zu gleichen Volumenanteilen), eine weitere optische Abstandshalterschicht (4) bestehend aus p-dotiertem BF-DPB (die gleichzeitig als Transportschicht für Löcher dient), eine weitere Spiegelschicht (3) aus Silber (die gleichzeitig als Elektrode fungiert), eine Barriereschicht (15) bestehend aus den Einzelschichten Molybdäntrioxid (MoO₃) und tris (8-hydroxy-quinolinato)-aluminium (Alq3) sowie eine Verkapselung (14) bestehend aus einem Deckglas aufgetragen mittels eines Klebstoffs. Die beiden als Elektroden dienenden Spiegelschichten (3) sind elektrisch über eine Auslese-Einheit (7) miteinander verbunden. Trifft Strahlung (16) der Detektionswellenlänge des Bauelements (1) von der Strahlungsquelle (9) auf die substratferne Spiegelschicht (3), bildet sich innerhalb der optischen Mikrokavität (das heißt zwischen den Spiegelschichten (3)) eine stehende Welle (10) mit räumlichem Intensitätsmaximum bezüglich der Detektionswellenlänge in der photoaktiven Schicht (5) aus. Die Schichtdicken sind so angepasst, dass die Wellenlänge mit konstruktiver Interferenz-Bedingung (d.h. die Detektionswellenlänge) im Bereich der Absorption des direkten interchromophoren Ladungstransferzustands liegt. Trifft Strahlung (17) von der Strahlungsquelle (9) verschieden der Detektionswellenlänge des Bauelementes (1) auf die substratferne Spiegelschicht, wird diese an der substratfernen Spiegelschicht (3) reflektiert (18).

Der Fig. 11 ist ein erfindungsgemäßes optoelektronisches Bauelement (1a) zu entnehmen, welches die folgende Schichtabfolge aufweist: Substrat (2) aus Polyethylenterephthalat (PET), Spiegelschicht (3) bestehend aus einer mehrfachen Abfolge von Siliziumdioxid (SiO₂) und Titandioxid (TiO₂) (DBR-Spiegelschicht), eine transparente, strukturierte Silber-Spiegelschicht im Sinne einer segment-artig strukturierten Elektrode (19), eine optische Abstandshalterschicht (4) bestehend aus n-dotiertem C60 (die gleichzeitig als Transportschicht für Elektronen dient sowie Wellenlängen aus dem sichtbaren Wellenlängenbereich passiv absorbiert (d.h. ohne anschließenden Beitrag zum Photostrom)), eine photoaktive Schicht (5) bestehend aus einer Eisenphthalocyanin(FePc):C60-Mischschicht (zu gleichen Volumenanteilen), eine weitere optische Abstandshalterschicht (4) bestehend aus p-dotiertem FePc (die gleichzeitig als Transportschicht für Löcher dient sowie Wellenlängen aus dem sichtbaren Wellenlängenbereich passiv absorbiert), eine weitere Spiegelschicht (3) aus Silber (die gleichzeitig als Elektrode fungiert), eine Barriereschicht (15) bestehend aus MoO₃, Alq3 und einer atomlagenabgeschiedenen (englisch: atomic layer deposition, kurz ALD) Aluminiumoxidschicht (Al₂O₃) sowie eine Verkapselung (14) bestehend aus einer Deckfolie aus PET aufgetragen mittels eines Klebstoffs. Jedes untere Elektrodensegment (19) ist über eine separate Auslese-Einheit (7) mit der substratfernen Elektrode (Spiegelschicht (3)) verbunden. Trifft Strahlung (16) der Detektionswellenlänge des Bauelementes (1a) entsprechend von der Strahlungsquelle (9) auf die substratferne Spiegelschicht (3), bildet sich innerhalb der optischen Mikrokavität (d.h. zwischen den Spiegelschichten (3)) eine stehende Welle (10) mit räumlichem Intensitätsmaximum bezüglich der Detektionswellenlänge in der photoaktiven Schicht (5) aus. Die Schichtdicken sind so angepasst, dass die Wellenlänge mittels konstruktiver Interferenz-Bedingung (d.h. die Detektionswellenlänge) im Bereich der Absorption des direkten interchromophoren Ladungstransferzustands liegt. Trifft Strahlung (17) verschieden der Detektionswellenlänge des Bauelementes (1a) von der Strahlungsquelle (9) auf die substratferne Spiegelschicht (3), wird diese an der substratfernen Spiegelschicht (3) reflektiert (18). Im Gegensatz zum in Fig. 10 dargestellten erfindungsgemäßen Bauteil kann der Detektor (1a) aufgrund der Strukturierung das Nahinfrarot-Signal räumlich auflösen. Außerdem beschleunigt sich aufgrund der geringeren aktiven Fläche die Antwortzeit des Bauteils (1a). Weiterhin ist dieses erfindungsgemäße optoelektronische Bauteil (1a) mechanisch flexibel ausgestaltet.

Der Fig. 12 ist ein erfindungsgemäßes optoelektronisches Bauelement (1b) zu entnehmen, welches die folgende Schichtabfolge aufweist: Substrat (2) aus Glas, Spiegelschicht (3) bestehend aus einer mehrfachen Abfolge von Siliziumdioxid (SiO₂) und Titandioxid (TiO₂) (DBR-Spiegelschicht), eine optische Abstandshalterschicht (4) bestehend aus PEDOT:PSS, eine für die Detektionswellenlänge hoch-transparente Elektrode (11) bestehend aus Indiumzinnoxid (ITO), eine löcherleitende Transportschicht (24) bestehend aus p-dotiertem Tetraphenyldipyranylidene (kurz TPDP), eine photoaktive Schicht (5) bestehend aus einer TPDP:C60-Mischschicht (zu gleichen Volumenanteilen), eine elektronenleitende Transportschicht (24) bestehend aus Bathophenanthroline (kurz Bphen), eine für die Detektionswellenlänge hoch-transparente Elektrode (11) bestehend aus Indiumzinnoxid (ITO), eine weitere optische Abstandshalterschicht (4) bestehend aus undotiertem BF-DPB, eine weitere Spiegelschicht (3) bestehend aus einer mehrfachen Abfolge von Siliziumdioxid (SiO₂) und Titandioxid (TiO₂) (DBR-Spiegelschicht), eine Barriereschicht (15) bestehend aus | MoO₃ und Alq3, optische Filterschichten (21) für den sichtbaren Wellenlängenbereich bestehend aus ZnPc und P4-2,3,10,11-tetrapropyl-1,4,9,12-tetraphenyl-diindeno[1,2,3-cd:1',2',3'-Im]perylene (P4-Ph4-DIP) sowie eine Verkapselung (14) bestehend aus einem Deckglas aufgetragen mittels eines Klebstoffs. Die beiden Elektroden (11) sind elektrisch über eine Auslese-Einheit (7) miteinander verbunden. Das erfindungsgemäße Bauelement (1b) erzeugt Photostrom, insofern von der Strahlungsquelle (9) ausgehende elektromagnetische Strahlung (20) im Infrarotbereich liegt und der Detektionswellenlänge des Bauteils (1b) entspricht.

Die optischen Dicken beider optischer Abstandshalterschichten (4) sind so gewählt, dass sich bezüglich einer im Absorptionsbereich des direkten interchromophoren Ladungstransferzustandes befindlichen Wellenlänge innerhalb der optischen Mikrokavität eine stehende Welle mit maximaler Intensität in der photoaktiven Schicht (5) ausbildet. In dieser Ausgestaltung des erfindungsgemäßen Detektors ist die Spiegelschicht nicht als Elektrode ausgebildet. Weiterhin übernehmen in dieser Umsetzung die optischen Abstandshalterschichten (4) keine elektrisch leitende Funktion. Durch die Verwendung hochreflektierender DBR-Spiegelflächen sowohl für die substratferne als auch substratnahe Spiegelfläche wird die Absorption des direkten interchromophoren Ladungstransferzustandes besonders vorteilhaft verstärkt.

Der Fig. 13 ist ein erfindungsgemäßes optoelektronisches Bauelement (1c) zu entnehmen, welches die folgende Schichtabfolge aufweist: Substrat (2) aus Glas, eine Spiegelschicht (3) aus Aluminium, eine optische Abstandshalterschicht (4) bestehend aus PEDOT:PSS, eine Schichtabfolge parallel zum Substrat (2) mit folgender Anordnung von links nach rechts:
eine Silber-Elektrode (11), eine löcherleitende Transportschicht (24) bestehend aus p-dotiertem 9,9-bis[4-(N,N-bis-biphenyl-4-yl-amino)phenyl]-9H-fluorene (kurz BPAPF), eine photoaktive Schicht (5) bestehend aus einer 4,4',4"-tris(3-methylphenylphenylamino)-triphenylamine (kurz m-MTDATA)-C60-Mischschicht (zu gleichen Volumenanteilen), eine elektronenleitende Transportschicht (24) bestehend aus Caesium-dotiertem BPhen sowie eine Silber-Elektrode (11). Oberhalb der Schichtabfolge parallel zum Substrat folgt eine weitere optische Abstandshalterschicht (4) bestehend aus C60, eine weitere Spiegelschicht (3) aus Silber, eine Barriereschicht (15) bestehend aus | MoO₃ und Alq3 sowie eine Verkapselung (14) bestehend aus einem Deckglas aufgetragen mittels eines Klebstoffs. Die beiden Elektroden (11) sind elektrisch über eine Auslese-Einheit (7) miteinander verbunden. Das erfindungsgemäße Bauelement (1c) erzeugt Photostrom, insofern von der Strahlungsquelle (9) ausgehende elektromagnetische Strahlung (20) im Nah-Infrarotbereich liegt und der Detektionswellenlänge des Bauteils entspricht.

Die optischen Dicken beider optischer Abstandshalterschichten (4) sind so gewählt, dass sich bezüglich einer im Absorptionsbereich des direkten interchromophoren Ladungstransferzustandes befindlichen Wellenlänge innerhalb der optischen Mikrokavität eine stehende Welle mit maximaler Intensität in der photoaktiven Schicht (5) ausbildet. In dieser Ausgestaltung des erfindungsgemäßen Detektors (1c) ist die Spiegelschicht (3) nicht gleichzeitig als Elektrode ausgebildet. Weiterhin übernehmen in dieser Umsetzung die optischen Abstandshalterschichten (4) keine elektrisch leitende Funktion. Besonders vorteilhaft erweist sich in dieser Umsetzung, dass durch räumliches Versetzen der Elektroden (11) außerhalb der zur Absorption der Nahinfrarotstrahlung genutzten Fläche parasitäre Absorption (d.h. Absorption aller sich in der optischen Mikrokavität befindlichen, von der photoaktiven Schicht verschiedenen Schichten) gering ist, wodurch die Intensität des optischen Feldes bei der Resonanz-Wellenlänge ansteigt.

Der Fig. 14 ist ein erfindungsgemäßes optoelektronisches Bauelement (1d) zu entnehmen, welches die folgende Schichtabfolge aufweist: ein mit einer Photolackschicht (zum Beispiel ma-P1210) lateral strukturiertes Glassubstrat (23), eine bezüglich der Detektionswellenlänge hoch-transparente Elektrode (11) aus ITO, eine optische Abstandshalterschicht (4) bestehend aus n-dotiertem Bis-Hfl-NTCDI (die gleichzeitig als Transportschicht für Elektronen dient), eine photoaktive Schicht (5) bestehend aus einer Blei-Phthalocyanin (kurz PbPc):C60-Mischschicht (zu gleichen Volumenanteilen), eine weitere optische Abstandshalterschicht (4) bestehend aus p-dotiertem BF-DPB (die gleichzeitig als Transportschicht für Löcher dient), eine weitere Elektrode (11) aus Silber, eine Barriereschicht (15) bestehend aus | MoO₃ und Alq3 sowie ein inertes Gas (22), etwa Stickstoff, und eine Verkapselung (14) bestehend aus einem Deckglas aufgetragen mittels eines Klebstoffs. Die Spiegelflächen sind in dieser Umsetzung einerseits das lateral strukturierte Substrat (23) sowie die Grenzfläche zwischen der Barriereschicht (15) und dem inerten Gas (22). Die beiden Elektroden (11) sind elektrisch über eine Auslese-Einheit (7) miteinander verbunden. Die Detektionswellenlänge des Bauelements (1d) ist durch den optischen Abstand der beiden Spiegelflächen sowie der Periodenstruktur des Substrates (23) so einzustellen, dass die Wellenlänge mittels konstruktiver Interferenz-Bedingung im Wellenlängenbereich der Absorption des direkten interchromophoren Ladungstransferzustandes liegt. In diesem Bauelement (1d) mit strukturierter, substratnaher Spiegelfläche (d.h. eindimensionale Interferenzgitter, DFB-Struktur) findet Lichtwellenleitung parallel zum Substrat (23) statt. Das erfindungsgemäße Bauelement (1d) erzeugt Photostrom, insofern von der Strahlungsquelle (9) ausgehende elektromagnetische Strahlung (20) im Nah-Infrarotbereich liegt und der Detektionswellenlänge des Bauteils (1d) entspricht.

Der Fig. 15 ist ein erfindungsgemäßes optoelektronisches Bauelement (1e) zu entnehmen, welches aus den gleichen Schichten in gleicher Reihenfolge wie Fig. 11 besteht. Im Gegensatz zu Fig. 11 liegt in den beiden optischen Abstandshalterschichten (4) eine Schichtdickenvariation parallel zum Substrat vor. Somit bilden sich für jede, durch ein Elektroden-Segment (19) abgegrenzte Fläche der optischen Mikrokavität unterschiedliche Resonanz-Wellenlängen bzw. Detektionswellenlängen aus. Während das optoelektronische Bauteil aus Fig. 11 das eintreffende, elektromagnetische Signal räumlich auflöst, löst das hier dargestellte Bauteil (1e) das eintreffende, elektromagnetische Signal spektral auf. Das erfindungsgemäße Bauelement (1e) erzeugt Photostrom, insofern von der Strahlungsquelle (9) ausgehende elektromagnetische Strahlung (20) im Nah-Infrarotbereich liegt und den Detektionswellenlängen des Bauteils entspricht.

Der Fig. 16 ist ein erfindungsgemäßes optoelektronisches Bauelement (1f) zu entnehmen, welches aus den gleichen Schichten in gleicher Reihenfolge wie Fig. 10 besteht. Im Gegensatz zum in Fig. 10 gezeigten Ausführungsbeispiel sind die Schichten (3, 4, 5, 4, 3, 15) lateral in elektrisch isolierte, jeweils einzeln mit einer Auslese-Einheit (7) verbundene Segmente strukturiert. Die Spiegelschicht (3) fungiert wiederum als Elektrode. Wie bereits in Fig. 15 liegt auch hier eine Schichtdickenvariation des Spiegelabstandes parallel zum Substrat (2) vor. Im Gegensatz zu Fig. 15 ist diese jedoch nicht keilförmig, sondern stufenartig umgesetzt mittels diskret abgestufter Schichtdickenvariation der photoaktiven Schicht (5). Somit ist jedem elektrisch isoliertem Segment eine separate Detektionswellenlänge zugewiesen. Wie auch in Fig. 15 löst das beschriebene optoelektronische Bauelement (1f) das eintreffende, elektromagnetische Signal spektral auf.

### Bezugszeichenliste

- 1, 1a, 1b, 1c, 1d, 1e, 1f: Photosensitives, optoelektronisches Bauelement
- 2: Substrat
- 3: Spiegelschicht
- 4: Optische Abstandshalterschicht
- 5: Photoaktive Schicht
- 7: Auslese-Einheit
- 9: Strahlungsquelle
- 10: Stehende Welle für Resonanz-Wellenlänge der optischen Mikrokavität
- 11: Elektrode
- 14: Verkapselung
- 15: Barriereschicht
- 16: Von der Strahlungsquelle emittierte elektromagnetische Strahlung mit der Resonanz-Wellenlänge
- 17: Von der Strahlungsquelle emittierte elektromagnetische Strahlung verschieden der Resonanz-Wellenlänge
- 18: Am Detektor reflektierte Wellenlänge verschieden der Resonanz-Wellenlänge
- 19: Segmentartig strukturierte Elektrode
- 20: Von der Strahlungsquelle emittierte elektromagnetische Strahlung
- 21: Optische Filterschicht für sichtbaren Wellenlängenbereich
- 22: Inertes Gas
- 23: Lateral strukturiertes Substrat
- 24: Transportschicht

## Patentansprüche

1. Verfahren zur Detektion eines elektromagnetischen Signals im Wellenlängenbereich von 780 nm bis 10 µm, aufweisend die Schritte:
a) Bereitstellung eines optoelektronischen Bauelements (1, 1a, 1b, 1c, 1d, 1e, 1f), das auf einem Substrat (2) angeordnet ist und
**i.** zwei voneinander beabstandete und sich gegenüberliegende Spiegelflächen aufweist, die eine optische Mikrokavität ausbilden,
**ii.** eine zwischen den Spiegelflächen angeordnete photoaktive Schicht (5) aufweist, enthaltend mindestens eine Verbindung 1 und eine Verbindung 2,
wobei die Energiedifferenz zwischen der HOMO-Energie der Verbindung 1 und der LUMO-Energie der Verbindung 2 unterhalb 1,6 eV liegt,
wobei die optische Weglänge zwischen den Spiegelflächen im Bereich von 25 bis 75% der Wellenlänge des zu detektierenden Signals entspricht, und
wobei das Energieäquivalent des Wellenlängenbereichs des zu detektierenden elektromagnetischen Signals im Bereich von
- der Energiedifferenz definiert durch die HOMO-Energie der Verbindung 1 und die LUMO-Energie der Verbindung 2 und
- der Energiedifferenz definiert durch die HOMO-Energie und die LUMO-Energie der Verbindung 1 liegt,
wobei die photoaktive Schicht (5) innerhalb der optischen Mikrokavität im räumlichen Intensitätsmaximum der Wellenlänge des zu detektierenden elektromagnetischen Signals zwischen den Spiegelflächen ausgerichtet ist;
b) Bestrahlen des optoelektronischen Bauelements (1, 1a, 1b, 1c, 1d, 1e, 1f) mit einem elektromagnetischen Signal im Wellenlängenbereich von 780 nm bis 10 µm;
c) Verstärkung des zu detektierenden elektromagnetischen Signals innerhalb der optischen Mikrokavität, wobei, durch die Wellenlänge des zu detektierenden Signals induziert, ein direkter interchromophorer Ladungstransfer von der Verbindung 1 auf die Verbindung 2 erfolgt;
d) Umwandlung des elektromagnetischen Signals in ein elektrisches Signal.

2. Verfahren nach Anspruch 1, **dadurch gekennzeichnet, dass** innerhalb der optischen Mikrokavität zwei optische Abstandshalterschichten (4) angeordnet sind.

3. Verfahren nach Anspruch 1 oder 2, **dadurch gekennzeichnet, dass** die zwei sich gegenüberliegenden Spiegelflächen planparallel mit einem geometrischen Abstand im Bereich von 100 nm und 5000 nm zueinander angeordnet sind.

4. Verfahren nach einem der Ansprüche 1 oder 2, **dadurch gekennzeichnet, dass** das elektromagnetische Signal spektral aufgelöst detektiert wird, wobei der geometrische Abstand der zwei sich gegenüberliegenden Spiegelflächen des optoelektronischen Bauelements (1e, 1f) in mindestens einer lateralen Richtung kontinuierlich oder diskontinuierlich variiert.

5. Verfahren nach Anspruch 4, **dadurch gekennzeichnet, dass** die zwei sich gegenüberliegenden Spiegelflächen gekippt mit einer kontinuierlichen Varianz des geometrischen Abstandes im Bereich von 1 nm bis 500 nm und einem mittleren geometrischen Abstand im Bereich von 100 nm und 5000 nm zueinander angeordnet sind.

6. Verfahren nach Anspruch 4, **dadurch gekennzeichnet, dass** die zwei sich gegenüberliegenden Spiegelflächen mit einer diskontinuierlichen Varianz der geometrischen Abstandes angeordnet sind, wobei das optoelektronische Bauelement (1f) elektrisch voneinander isolierte Segmente aufweist, innerhalb derer die zwei sich gegenüberliegenden Spiegelflächen planparallel angeordnet sind, wobei sich der geometrische Abstand der zwei sich gegenüberliegenden Spiegelflächen in benachbarten Segmenten voneinander unterscheidet.

7. Verfahren nach einem der vorgenannten Ansprüche, **dadurch gekennzeichnet, dass** die Verbindung 1 und die Verbindung 2 in der photoaktiven Schicht (5) durchmischt vorliegen.

8. Verfahren nach einem der vorgenannten Ansprüche, **dadurch gekennzeichnet, dass** das elektrische Signal über Elektroden (3, 11, 19) sowie mindestens eine Auslese-Einheit (7) ausgelesen und gegebenenfalls weiterverarbeitet wird.

9. Verfahren nach einem der vorgenannten Ansprüche, **dadurch gekennzeichnet, dass** das Auslesen des elektrischen Signals durch Anlegen einer externen Spannung im Bereich zwischen 0 und -100 V an Elektroden (3, 11, 19) des optoelektronischen Bauelements (1, 1a, 1b, 1c, 1d, 1e, 1f) unterstützt wird.

10. Verfahren nach einem der vorgenannten Ansprüche, **dadurch gekennzeichnet, dass** die Verstärkung des zu detektierenden Signals innerhalb der optischen Mikrokavität in Schritt (c) durch mindestens einen der Effekte plasmonische, dielektrische oder Total-Reflexion erfolgt.

11. Verfahren nach einem der vorgenannten Ansprüche, **dadurch gekennzeichnet, dass** die über die photoaktive Schicht (5) gemittelte Intensität des zu detektierenden elektromagnetischen Signals in Schritt (c) um den Faktor 10 bis 10000 verstärkt wird.

12. Optoelektronisches Bauelement (1, 1a, 1b, 1c, 1d, 1e, 1f) auf einem Substrat (2) für die Detektion eines elektromagnetischen Signals im Wellenlängenbereich von 780 nm bis 10 µm, aufweisend zumindest:
i. zwei voneinander beabstandete und sich gegenüberliegende Spiegelflächen, die eine optische Mikrokavität ausbilden,
ii. eine zwischen den Spiegelflächen angeordnete photoaktive Schicht (5), enthaltend mindestens eine Verbindung 1 und eine Verbindung 2,
wobei die Energiedifferenz zwischen der HOMO-Energie der Verbindung 1 und der LUMO-Energie der Verbindung 2 unterhalb 1,6 eV liegt,
wobei die optische Weglänge zwischen den Spiegelflächen im Bereich von 25 bis 75% der Wellenlänge des zu detektierenden Signals entspricht und
wobei das Energieäquivalent des Wellenlängenbereichs des zu detektierenden elektromagnetischen Signals im Bereich von
- der Energiedifferenz definiert durch die HOMO-Energie der Verbindung 1 und die LUMO-Energie der Verbindung 2 und
- der Energiedifferenz definiert durch die HOMO-Energie und die LUMO-Energie der Verbindung 1 liegt,
wobei die photoaktive Schicht (5) innerhalb der optischen Mikrokavität im räumlichen Intensitätsmaximum der Wellenlänge des zu detektierenden elektromagnetischen Signals zwischen den Spiegelflächen ausgerichtet ist.

13. Optoelektronisches Bauelement (1b) nach Anspruch 12, **dadurch gekennzeichnet, dass** das optoelektronische Bauelement (1b) löcher- bzw. elektronenleitende Transportschichten (24) aufweist.

14. Optoelektronisches Bauelement (1, 1a, 1b, 1c, 1d, 1e, 1f) nach Anspruch 12 oder 13, **dadurch gekennzeichnet, dass** das optoelektronische Bauelement (1, 1a, 1b, 1c, 1d, 1e, 1f) optische Filterschichten (21) und/oder Ladungsträger-Blockierschichten und/oder Keimschichten und/oder Barriereschichten (15) und/oder eine Verkapselung (14) aufweist.

15. Optoelektronisches Bauelement (1f) nach einem der Ansprüche 12 bis 14, **dadurch gekennzeichnet, dass** das optoelektronische Bauelement (1f) eine laterale Strukturierung in elektrisch voneinander isolierte Segmente aufweist, wobei zumindest der geometrische Abstand zwischen den zwei sich gegenüberliegenden Spiegelflächen segmentweise variiert.

16. Verwendung eines Verfahrens nach einem der Ansprüche 1 bis 11 oder eines optoelektronischen Bauelements (1, 1a, 1b, 1c, 1d, 1e, 1f) nach einem der Ansprüche 12 bis 15 zum Erfassen elektromagnetischer Strahlung im Wellenlängenbereich von 780 nm bis 10 µm mit räumlicher, zeitlicher und/oder spektraler Auflösung sowie zu deren Weiterverarbeitung.

17. Verwendung eines optoelektronischen Bauelements (1, 1a, 1b, 1c, 1d, 1e, 1f) nach einem der Ansprüche 12 bis 15 als Solarzelle oder als Komponente einer Solarzelle.

## Claims

1. A method for detecting an electromagnetic signal in the wavelength range of 780 nm to 10 µm, comprising the steps of:
a) providing an optoelectronic component (1, 1a, 1b, 1c, 1d, 1e, 1f) that is arranged on a substrate (2), and has
i. two mirror surfaces which are spaced apart from and opposing one another and which form an optical micro activity,
ii. a photoactive layer (5) arranged between the mirror surfaces and comprising at least one compound 1 and one compound 2,
wherein the energy difference between the HOMO energy of the compound 1 and the LUMO energy of the compound 2 lies below 1.6 eV,
wherein the optical path length between the mirror surfaces corresponds in the range of 25 to 75% to the wavelength of the signal to be detected, and
wherein the energy equivalent of the wavelength range of the electromagnetic signal to be detected lies in range of
- the energy difference defined by the HOMO energy of the compound 1 and the LUMO energy of the compound 2, and
- the energy difference defined by the HOMO energy and the LUMO energy of the compound 1,
wherein the photoactive layer (5) is aligned, within the optical micro activity in the spatial intensity maximum of the wavelength of the electromagnetic signal to be detected, between the mirror surfaces;
b) irradiating the optoelectronic component (1, 1a, 1b, 1c, 1d, 1e, 1f) with an electromagnetic signal in the wavelength range of 78 nm to 10 µm;
c) amplifying the electromagnetic signal to be detected within the optical micro activity, wherein, induced by the wavelength of the signal to be detected, a direct interchromophoric charge transfer from the compound 1 to the compound 2 takes place;
d) converting the electromagnetic signals into an electrical signal.

2. The method according to claim 1, **characterized in that** within the optical micro activity there are arranged two optical spacer layers (4).

3. The method according to claim 1 or 2, **characterized in that** the two opposing mirror surfaces are arranged plane-parallel to one another with a geometric distance in the range of 100 nm and 5000 nm.

4. The method according to any one of claim 1 or 2, **characterized in that** the electromagnetic signal is detected in a spectrally resolved manner, wherein the geometric distance between the two opposing mirror surfaces of the optoelectronic component (1e, 1f) varies continuously or discontinuously in at least one lateral direction.

5. The method according to claim 4, **characterized in that** the two opposing mirror surfaces are arranged tilted with a continuous variance of the geometric distance in the range of 1 nm to 500 nm and an average geometric distance in the range of 100 nm and 5000 nm.

6. The method according to claim 4, **characterized in that** the two opposing mirror surfaces are arranged with a discontinuous variance of the geometric distance, wherein the optoelectronic component (1f) has segment which are electrically insulated from one another and within which the two opposing mirror surfaces are arranged in a plane-parallel manner, wherein the geometric distance of the two opposing mirror surfaces differs from one another in adjacent segments.

7. The method according to any one of the preceding claims, **characterized in that** the compound 1 and the compound 2 are present in the photoactive layer (5) in a mixed manner.

8. The method according to any one of the preceding claims, **characterized in that** the electrical signal is read out via electrodes (3, 11, 19) as well as at least one read-out unit (7) and is optionally further processed.

9. The method according to any one of the preceding claims, **characterized in that** reading out the electrical signal is supported by applying an external voltage in the range between 0 and -100 V to electrodes (3, 11, 19) of the optoelectronic components (1, 1a, 1b, 1c, 1d, 1e, 1f) .

10. The method according to any one of the preceding claims, **characterized in that** the amplification of the signal to be detected within the micro activity in step (c) is carried out by at least one of the effects plasmonic, dielectric or total reflection.

11. The method according to any one of the preceding claims, **characterized in that** the intensity of the electromagnetic signal to be detected, which intensity is averaged over the photoactive layer (5), is amplified by the factor 10 to 10000 in step (c).

12. An optoelectronic component (1, 1a, 1b, 1c, 1d, 1e, 1f) on a substrate (2) for detecting an electromagnetic signal in the wavelength range of 780 nm to 10 µm, comprising at least:
i. two mirror surfaces which are spaced apart from and opposing one another and which form an optical micro activity,
ii. a photoactive layer (5) arranged between the mirror surfaces and comprising at least one compound 1 and one compound 2,
wherein the energy difference between the HOMO energy of the compound 1 and the LUMO energy of the compound 2 lies below 1.6 eV,
wherein the optical path length between the mirror surfaces corresponds in the range of 25 to 75% to the wavelength of the signal to be detected, and
wherein the energy equivalent of the wavelength range of the electromagnetic signal to be detected lies in range of
- the energy difference defined by the HOMO energy of the compound 1 and the LUMO energy of the compound 2, and
- the energy difference defined by the HOMO energy and the LUMO energy of the compound 1,
wherein the photoactive layer (5) is aligned, within the optical micro activity in the spatial intensity maximum of the wavelength of the electromagnetic signal to be detected, between the mirror surfaces.

13. The optoelectronic component (1b) according to claim 12, **characterized in that** the optoelectronic component (1b) has hole-conducting or electron-conducting transport layers (24).

14. The optoelectronic component (1, 1a, 1b, 1c, 1d, 1e, 1f) according to claim 12 or 13, **characterized in that** the optoelectronic component (1, 1a, 1b, 1c, 1d, 1e, 1f) has optical filter layers (21) and/or charge carrier blocking layers and/or germ layers and/or barrier layers (15) and/or an encapsulation (14).

15. The optoelectronic component (1f) according to any one of claims 12 to 14, **characterized in that** the optoelectronic component (1f) has a lateral structuring in segments that are electrically insulated from one another, wherein at least the geometrical distance between two opposing mirror surfaces varies segmentally.

16. The use of a method according to any one of claims 1 to 11 or of an optoelectronic component (1, 1a, 1b, 1c, 1d, 1e, 1f) according to any one of claims 12 to 15 for detecting electromagnetic radiation in the wavelength range of 780 nm to 10 µm with spatial, temporal and/or spectral resolution as well as for further processing thereof.

17. The use of an optoelectronic component (1, 1a, 1b, 1c, 1d, 1e, 1f) according to any one of claims 12 to 15 as a solar cell or as a component of a solar cell.

## Revendications

1. Procédé pour la détection d'un signal électromagnétique dans la plage de longueurs d'onde de 780 nm à 10 µm, comprenant les étapes suivantes :
a) mise à disposition d'un élément de construction optoélectronique (1, 1a, 1b, 1c, 1d, 1e, 1f) disposé sur un substrat (2), et
i. présentant deux surfaces réfléchissantes opposées et espacées l'une de l'autre, formant une microcavité optique,
ii. présentant une couche photo-active (5) disposée entre les surfaces réfléchissantes, contenant au moins un composé 1 et un composé 2,
dans lequel la différence d'énergie entre l'énergie HOMO du composé 1 et l'énergie LUMO du composé 2 est inférieure à 1,6 eV,
dans lequel la longueur de trajet optique entre les surfaces réfléchissantes est comprise entre 25 et 75% de la longueur d'onde du signal à détecter, et
dans lequel l'équivalent d'énergie de la plage de longueurs d'onde du signal électromagnétique à détecter se trouve dans la plage
- de la différence d'énergie définie par l'énergie HOMO du composé 1 et l'énergie LUMO du composé 2, et
- de la différence d'énergie définie par l'énergie LOMO et l'énergie LUMO du composé 1,
dans lequel la couche photo-active (5) est orientée entre les surfaces réfléchissantes à l'intérieur de la microcavité optique dans le maximum d'intensité spatial de la longueur d'onde du signal électromagnétique à détecter ;
b) irradiation de l'élément de construction optoélectronique (1, 1a, 1b, 1c, 1d, 1e, 1f) avec un signal électromagnétique dans la plage de longueurs d'onde de 780 nm à 10 µm ;
c) amplification du signal électromagnétique à détecter à l'intérieur de la microcavité optique, moyennant quoi un transfert de charge interchromophore direct du composé 1 vers le composé 2 est induit par la longueur d'onde du signal à détecter ;
d) conversion du signal électromagnétique en un signal électrique.

2. Procédé selon la revendication 1, **caractérisé en ce que** deux couches d'espaceur optique (4) sont disposées à l'intérieur de la microcavité optique.

3. Procédé selon la revendication 1 ou 2, **caractérisé en ce que** les deux surfaces réfléchissantes opposées sont disposées de façon plane et parallèle l'une par rapport à l'autre avec un écart géométrique dans la plage de 100 nm à 5000 nm.

4. Procédé selon l'une des revendications 1 ou 2, **caractérisé en ce que** le signal électromagnétique est détecté par résolution spectrale, dans lequel l'écart géométrique entre les deux surfaces réfléchissantes opposées de l'élément de construction optoélectronique (1e, 1f) variant de façon continue ou discontinue au moins dans une direction latérale.

5. Procédé selon la revendication 4, **caractérisé en ce que** les deux surfaces réfléchissantes opposées sont disposées de façon inclinée l'une par rapport à l'autre avec une variance continue de l'écart géométrique dans la plage 1 nm à 500 nm et un écart géométrique moyen dans la plage de 100 nm à 5000 nm.

6. Procédé selon la revendication 4, **caractérisé en ce que** les deux surfaces réfléchissantes opposées sont disposées avec une variance discontinue de l'écart géométrique, dans lequel l'élément de construction optoélectronique (1f) comporte des segments électriquement isolés les uns par rapport aux autres, à l'intérieur desquels les deux surfaces réfléchissantes opposées sont disposées de façon plane et parallèle, l'écart géométrique des deux surfaces réfléchissantes opposées étant différent dans des segments voisins.

7. Procédé selon l'une des revendications précédentes, **caractérisé en ce que** le composé 1 et le composé 2 sont mélangés dans la couche photo-active (5).

8. Procédé selon l'une des revendications précédentes, **caractérisé en ce que** le signal électrique est lu par le biais d'électrodes (3, 11, 19) et d'au moins une unité de lecture (7) et traité ultérieurement le cas échéant.

9. Procédé selon l'une des revendications précédentes, **caractérisé en ce que** la lecture du signal électrique est soutenue par l'application d'une tension externe dans la plage de 0 à -100 V à des électrodes (3, 11, 19) de l'élément de construction optoélectronique (1, 1a, 1b, 1c, 1d, 1e, 1f).

10. Procédé selon l'une des revendications précédentes, **caractérisé en ce que** l'amplification du signal à détecter à l'intérieur de la microcavité optique dans l'étape (c) est effectuée par au moins l'un des effets suivants : plasmonique, diélectrique ou réflexion totale.

11. Procédé selon l'une des revendications précédentes, **caractérisé en ce que** l'intensité du signal électromagnétique à détecter, moyennée par le biais de la couche photo-active (5), est amplifiée selon le facteur 10 à 10000.

12. Elément de construction optoélectronique (1, 1a, 1b, 1c, 1d, 1e, 1f) sur un substrat (2) pour la détection d'un signal électromagnétique dans la plage de longueurs d'onde de 780 nm à 10 µm, comprenant au moins :
i. deux surfaces réfléchissantes opposées et espacées l'une de l'autre, formant une microcavité optique,
ii. une couche photo-active (5) disposée entre les surfaces réfléchissantes, contenant au moins un composé 1 et un composé 2,
dans lequel la différence d'énergie entre l'énergie HOMO du composé 1 et l'énergie LUMO du composé 2 est inférieure à 1,6 eV,
dans lequel la longueur de trajet optique entre les surfaces réfléchissantes est comprise entre 25 et 75% de la longueur d'onde du signal à détecter, et
dans lequel l'équivalent d'énergie de la plage de longueurs d'onde du signal électromagnétique à détecter se trouve dans la plage
- de la différence d'énergie définie par l'énergie HOMO du composé 1 et l'énergie LUMO du composé 2, et
- de la différence d'énergie définie par l'énergie LOMO et l'énergie LUMO du composé 1,
dans lequel la couche photo-active (5) est orientée entre les surfaces réfléchissantes à l'intérieur de la microcavité optique dans le maximum d'intensité spatial de la longueur d'onde du signal électromagnétique à détecter.

13. Elément de construction optoélectronique (1b) selon la revendication 12, **caractérisé en ce que** l'élément de construction optoélectronique (1b) comporte des couches de transport à conduction électronique ou par lacunes (24).

14. Elément de construction optoélectronique (1, 1a, 1b, 1c, 1d, 1e, 1f) selon la revendication 12 ou 13, **caractérisé en ce que** l'élément de construction optoélectronique (1, 1a, 1b, 1c, 1d, 1e, 1f) comporte des couches de filtre optique (21) et/ou des couches de blocage de porteur de charge et/ou des couches d'ensemencement et/ou des couches barrières (15) et/ou un encapsulage (14).

15. Elément de construction optoélectronique (1f) selon l'une des revendications 12 à 14, **caractérisé en ce que** l'élément de construction optoélectronique (1f) comporte une structure latérale dans des segments électriquement isolés les uns par rapport aux autres, dans lequel au moins l'écart géométrique entre les deux surfaces réfléchissantes opposées varie par segments.

16. Utilisation d'un procédé selon l'une des revendications 1 à 11 ou d'un élément de construction optoélectronique (1, 1a, 1b, 1c, 1d, 1e, 1f) selon l'une des revendications 12 à 15, pour la détection d'un rayonnement électromagnétique dans la plage de longueurs d'onde de 780 nm à 10 µm, avec une résolution spatiale, temporelle et/ou spectrale, et pour le traitement ultérieur de celui-ci.

17. Utilisation d'un élément de construction optoélectronique (1, 1a, 1b, 1c, 1d, 1e, 1f) selon l'une des revendications 12 à 15 en tant que cellule solaire ou que composant d'une cellule solaire.
